# EUROPEAN PATENT APPLICATION

(11) **EP 4 648 592 A1**
(43) Date of publication of application: **12.11.2025**
(21) Application number: 23947050.3
(22) Date of filing: 31.07.2023
(51) Int. Cl.: H10K 59/35

(54) **PIXEL ARRANGEMENT STRUCTURE AND DISPLAY DEVICE**

(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: HU, Ming, Beijing 100176 (CN); XU, Qian, Beijing 100176 (CN); QIU, Haijun, Beijing 100176 (CN); ZHANG, Yi, Beijing 100176 (CN); JI, Fengli, Beijing 100176 (CN); ZHANG, Wei, Beijing 100176 (CN); DONG, Xiangdan, Beijing 100176 (CN); SONG, Gukhwan, Beijing 100176 (CN); HAO, Xueguang, Beijing 100176 (CN); WANG, Hongli, Beijing 100176 (CN); JIANG, Zhiliang, Beijing 100176 (CN); HUANG, Yan, Beijing 100176 (CN); WU, Jianpeng, Beijing 100176 (CN); LUO, Chang, Beijing 100176 (CN); ZHENG, Hai, Beijing 100176 (CN); WANG, Rui, Beijing 100176 (CN); XIE, Taofeng, Beijing 100176 (CN)
(74) Representative: Brötz, Helmut
(86) International application number: PCT/CN2023/110373
(87) International publication number: WO 2025/025101

(57) **Abstract**

A pixel arrangement structure and a display device. The pixel arrangement structure comprises at least one array unit; the array unit comprises a first pixel row, a second pixel row, a third pixel row, and a fourth pixel row; the first pixel row comprises a plurality of first sub-pixels arranged in a first direction; the second pixel row comprises a plurality of second sub-pixels and a plurality of third sub-pixels which are arranged in the first direction and are alternately arranged; the third pixel row comprises a plurality of first sub-pixels arranged in the first direction; the fourth pixel row comprises a plurality of second sub-pixels and a plurality of third sub-pixels which are arranged in the first direction and are alternately arranged; the first pixel row, the second pixel row, the third pixel row, and the fourth pixel row are arranged in a second direction, and lines connecting the centers of two adjacent first sub-pixels in the first pixel row and two adjacent first sub-pixels in the third pixel row form a virtual isosceles trapezoid. Therefore, the pixel arrangement structure can make distribution of virtual pixels (or white spot pixels) more uniform.

## Description

### TECHNICAL FIELD

Embodiments of the present disclosure relate to a pixel arrangement structure and a display device.

### BACKGROUND

With the diversified development of application fields and product forms of organic light-emitting diode (OLED) display devices, the demand for electronic products having organic light-emitting diode display devices is also increasing. These electronic products include smartphones, TVs, computers, tablets, navigators, car central control screens, and smart watches.

Organic light-emitting diode (OLED) display devices include driving substrates, organic light-emitting elements and encapsulation layers; each of the organic light-emitting elements includes an anode, a cathode and an organic light-emitting layer located between the anode and the cathode; each of the organic light-emitting elements is located on a driving substrate and connected with a pixel driving circuit on the driving substrate; each of the encapsulation layers is located on a side of the organic light-emitting element away from the driving substrate, so that the organic light-emitting element is packaged to prevent water and oxygen corrosion from causing deterioration of the organic light-emitting element.

In an organic light-emitting diode (OLED) display device, organic light-emitting elements can be arranged in an array on the driving substrate and serve as sub-pixels. A light-emitting layer of the organic light-emitting element is usually formed by evaporating organic light-emitting material at a corresponding position through a fine metal mask (FMM), therefore, an opening size of the fine metal mask directly determines sizes of the sub-pixels. Due to limitations in a manufacturing process of the fine metal mask, the opening size cannot be further reduced, it is difficult to obtain an organic light-emitting diode (OLED) display device with high resolution by using a conventional pixel arrangement structure.

### SUMMARY

Embodiments of the present disclosure provide a pixel arrangement structure and a display device including the pixel arrangement structure. The pixel arrangement structure can be modulated by modulating positions of sub-pixels of different colors, distribution of virtual pixels (or white point pixels) can be made more uniform, thus display problems such as "distortion" and "graininess" caused by the human eyes can be solved, and a better display effect can be achieved.

At least one embodiment of the present disclosure provides a pixel arrangement structure, which includes at least one array unit, the at least one array unit includes: a first pixel row, comprising a plurality of first sub-pixels arranged along a first direction; a second pixel row, comprising a plurality of second sub-pixels and a plurality of third sub-pixels, which are arranged along the first direction and alternately arranged; a third pixel row, comprising a plurality of first sub-pixels arranged along the first direction; and a fourth pixel row, comprising a plurality of second sub-pixels and a plurality of third sub-pixels, which are arranged along the first direction and alternately arranged, the first pixel row, the second pixel row, the third pixel row and the fourth pixel row are arranged along a second direction intersecting the first direction, and a virtual isosceles trapezoid is formed by lines sequentially connecting centers of two adjacent first sub-pixels in the first pixel row and centers of two adjacent first sub-pixels in the third pixel row.

For example, in the pixel arrangement structure provided by an embodiment of the present disclosure, a base angle of the virtual isosceles trapezoid ranges from 75 degrees to 90 degrees.

For example, in the pixel arrangement structure provided by an embodiment of the present disclosure, the base angle of the virtual isosceles trapezoid ranges from 82 degrees to 84 degrees.

For example, in the pixel arrangement structure provided by an embodiment of the present disclosure, the base angle of the virtual isosceles trapezoid ranges from 84 degrees to 86 degrees.

For example, in the pixel arrangement structure provided by an embodiment of the present disclosure, a virtual rectangle is formed by lines sequentially connecting centers of two adjacent third sub-pixels in the second pixel row and centers of two adjacent third sub-pixels in the fourth pixel row.

For example, in the pixel arrangement structure provided by an embodiment of the present disclosure, a virtual square is formed by the lines sequentially connecting the centers of the two adjacent third sub-pixels in the second pixel row and the centers of the two adjacent third sub-pixels in the fourth pixel row.

For example, in the pixel arrangement structure provided by an embodiment of the present disclosure, at least one of a virtual isosceles trapezoid, a virtual square, and a virtual quadrilateral is formed by lines sequentially connecting centers of two adjacent second sub-pixels in the second pixel row and centers of two adjacent second sub-pixels in the fourth pixel row.

For example, in the pixel arrangement structure provided by an embodiment of the present disclosure, a shape of each of the second sub-pixels comprises a first corner part and a second corner part arranged oppositely, a distance between a vertex of the first corner part and a geometric center of a corresponding second sub-pixel is greater than a distance between a vertex of the second corner part and the geometric center of the corresponding second sub-pixel, in the second pixel row and the fourth pixel row, arrangement orders of the first corner part and the second corner part of the two adjacent second sub-pixels are different.

For example, in the pixel arrangement structure provided by an embodiment of the present disclosure, arrangement orders of the first corner part and the second corner part of the two adjacent second sub-pixels in the second direction are opposite.

For example, in the pixel arrangement structure provided by an embodiment of the present disclosure, a curvature of a curve where the vertex of the first corner part is located is greater than a curvature of a curve where the vertex of the second corner part is located.

For example, in the pixel arrangement structure provided by an embodiment of the present disclosure, an arc length of an outer edge of the first corner part is less than an arc length of an outer edge of the second corner part.

For example, in the pixel arrangement structure provided by an embodiment of the present disclosure, each of the first sub-pixels is located within a range of a virtual quadrilateral formed by lines sequentially connecting centers of two adjacent second sub-pixels and centers of two adjacent third sub-pixels.

For example, in the pixel arrangement structure provided by an embodiment of the present disclosure, a first distance and a second distance are provided between the first sub-pixel and the two second sub-pixels for forming the virtual quadrilateral respectively, a third distance and a fourth distance are provided between the first sub-pixel and the two third sub-pixels for forming the virtual quadrilateral respectively, at least two of the first distance, the second distance, the third distance and the fourth distance are equal.

For example, in the pixel arrangement structure provided by an embodiment of the present disclosure, the first distance and the second distance are equal, and the third distance and the fourth distance are different.

For example, in the pixel arrangement structure provided by an embodiment of the present disclosure, the first distance, the second distance, the third distance and the fourth distance are equal.

For example, in the pixel arrangement structure provided by an embodiment of the present disclosure, the first sub-pixels are configured to emit green light.

For example, in the pixel arrangement structure provided by an embodiment of the present disclosure, the second sub-pixels are configured to emit blue light, and the third sub-pixels are configured to emit red light.

For example, in the pixel arrangement structure provided by an embodiment of the present disclosure, the second sub-pixels are configured to emit red light, and the third sub-pixels are configured to emit blue light.

For example, in the pixel arrangement structure provided by an embodiment of the present disclosure, the plurality of the second sub-pixels and the plurality of the third sub-pixels are alternately arranged along the second direction, to form a first pixel column, in the first pixel column, an angle between a line connecting centers of one of the second sub-pixels and one of the third sub-pixels adjacent to each other and the second direction ranges from 1 degree to 15 degrees.

For example, in the pixel arrangement structure provided by an embodiment of the present disclosure, in the first pixel column, the angle between the line connecting the one of the second sub-pixels and the one of the third sub-pixels adjacent to each other and the second direction ranges from 5 degrees to 7 degrees.

For example, in the pixel arrangement structure provided by an embodiment of the present disclosure, a shape of each of the second sub-pixels comprises a first corner part and a second corner part arranged oppositely, a distance between a vertex of the first corner and a geometric center of a corresponding second sub-pixel is greater than a distance between a vertex of the second corner and the geometric center of the corresponding second sub-pixel, in the first pixel column, the first corner part and the second corner part of the second sub-pixel are arranged oppositely in the second direction.

For example, in the pixel arrangement structure provided by an embodiment of the present disclosure, the plurality of the first sub-pixels are arranged along the second direction, to form a second pixel column, in the second pixel column, an angle between a line connecting centers of two adjacent first sub-pixels and the second direction ranges from 1 degree to 15 degrees.

For example, in the pixel arrangement structure provided by an embodiment of the present disclosure, the plurality of the first sub-pixels are arranged along the second direction, to form the second pixel column, in the second pixel column, the angle between the line connecting centers of the two adjacent first sub-pixels and the second direction ranges from 6 degrees to 8 degrees.

For example, in the pixel arrangement structure provided by an embodiment of the present disclosure, in the first pixel row, the plurality of the first sub-pixels are arranged at first intervals and second intervals along the first direction, the first intervals are smaller than the second intervals, and the first intervals and the second intervals are alternately arranged, two opposite corner parts of two of the first sub-pixels on two sides of a corresponding first interval are chamfered to form first chamfered parts.

For example, in the pixel arrangement structure provided by an embodiment of the present disclosure, two opposite corner parts of two of the first sub-pixels on two sides of a corresponding second interval are chamfered to form second chamfered parts.

For example, in the pixel arrangement structure provided by an embodiment of the present disclosure, a shape of each of the second sub-pixels comprises a first corner part and a second corner part arranged oppositely, a distance between a vertex of the first corner part and a geometric center of a corresponding second sub-pixel is greater than a distance between a vertex of the second corner part and the geometric center of the corresponding second sub-pixel, in the second pixel row and the fourth pixel row, arrangement orders of the first corner part and the second corner part of two adjacent second sub-pixels are the same.

For example, in the pixel arrangement structure provided by an embodiment of the present disclosure, in the second pixel row and the fourth pixel row, the first corner parts and the second corner parts of the two adjacent second sub-pixels are arranged oppositely in the second direction.

For example, in the pixel arrangement structure provided by an embodiment of the present disclosure, a virtual square is formed by lines sequentially connecting centers of the two adjacent second sub-pixels in the second pixel row and centers of the two adjacent second sub-pixels in the fourth pixel row.

For example, in the pixel arrangement structure provided by an embodiment of the present disclosure, an angle between a line connecting centers of one of the second sub-pixels and one of the third sub-pixels adjacent to each other and located in the second pixel row and the fourth pixel row respectively and the first direction ranges from 1 degree to 10 degrees, a line connecting centers of one of the second sub-pixels and one of the third sub-pixels adjacent to each other in the second direction is parallel to the second direction.

For example, in the pixel arrangement structure provided by an embodiment of the present disclosure, the angle between the line connecting the centers of one of the second sub-pixels and the one of the third sub-pixels adjacent to each other and located in the second pixel row and the fourth pixel row respectively and the first direction ranges 5 degrees to 9 degrees.

For example, in the pixel arrangement structure provided by an embodiment of the present disclosure, a shape of each of the second sub-pixels comprises a first corner part and a second corner part arranged oppositely, a distance between a vertex of the first corner part and a geometric center of a corresponding second sub-pixel is greater than a distance between a vertex of the second corner part and the geometric center of the corresponding second sub-pixel, in the second pixel row and the fourth pixel row, arrangement orders of the first corner part and the second corner part of two of the second sub-pixels adjacent to each other are the same, an arrangement direction of the first corner and the second corner of the second sub-pixels in the second pixel row is perpendicular to an arrangement direction of the first corner part and the second corner part of the second sub-pixels in the fourth pixel row.

For example, in the pixel arrangement structure provided by an embodiment of the present disclosure, lines sequentially connecting centers of two adjacent second sub-pixels in the second pixel row and centers of two adjacent second sub-pixels in the fourth pixel row form the virtual isosceles trapezoid.

For example, in the pixel arrangement structure provided by an embodiment of the present disclosure, an angle between a line connecting centers of one of the second sub-pixels and one of the third sub-pixels adjacent to each other and located in the second pixel row and the fourth pixel row respectively and the first direction ranges from 1 degree to 15 degrees, and an angle between a line connecting centers of one of the second sub-pixels and one of the third sub-pixels adjacent to each other in the second direction and the second direction ranges from 1 degree to 15 degrees.

For example, in the pixel arrangement structure provided by an embodiment of the present disclosure, an angle between a line connecting the centers of one of the second sub-pixels and the one of the third sub-pixels adjacent to each other and located in the second pixel row and the fourth pixel row respectively and the first direction ranges from 6 degrees to 8 degrees.

For example, in the pixel arrangement structure provided by an embodiment of the present disclosure, a shape of each of the second sub-pixels comprises a first corner part and a second corner part arranged oppositely, a distance between a vertex of the first corner part and a geometric center of a corresponding second sub-pixel is greater than a distance between a vertex of the second corner part and the geometric center of the corresponding second sub-pixel, in the second pixel row and the fourth pixel row, arrangement orders of the first corner part and the second corner part of two adjacent ones of the second sub-pixels are the same, and an arrangement direction of the first corner part and the second corner part of the second sub-pixels in the second pixel row is opposite to an arrangement direction of the first corner part and the second corner part of the second sub-pixels in the fourth pixel row.

For example, in the pixel arrangement structure provided by an embodiment of the present disclosure, an angle between a line connecting centers of one of the second sub-pixels and one of the third sub-pixels adjacent to each other and located in the second pixel row and the fourth pixel row respectively and the first direction ranges from 1 degree to 15 degrees, and an angle between a line connecting centers of one of the second sub-pixels and one of the third sub-pixels adjacent to each other in the second direction and the second direction ranges from 1 degree to 15 degrees.

For example, in the pixel arrangement structure provided by an embodiment of the present disclosure, the angle between the line connecting the centers of one of the second sub-pixels and one of the third sub-pixels adjacent to each other and located in the second pixel row and the fourth pixel row respectively and the first direction ranges from 7 degrees to 8 degrees.

For example, in the pixel arrangement structure provided by an embodiment of the present disclosure, a shape of each of the second sub-pixels comprises a first corner part and a second corner part arranged oppositely, a distance between a vertex of the first corner part and a geometric center of a corresponding second sub-pixel is greater than a distance between a vertex of the second corner part and the geometric center of the corresponding second sub-pixel, in the second pixel row and the fourth pixel row, arrangement orders of the first corner part and the second corner part of two adjacent ones of the second sub-pixels are the same, an arrangement direction of the first corner part and the second corner part of the second sub-pixels in the second pixel row is perpendicular to an arrangement direction of the first corner part and the second corner part of the second sub-pixels in the fourth pixel row, and arrangement orders of the first corner part and the second corner part of two adjacent ones of the second sub-pixels in the second direction are opposite.

For example, in the pixel arrangement structure provided by an embodiment of the present disclosure, an angle between a line connecting centers of one of the second sub-pixels and one of the third sub-pixels adjacent to each other and located in the second pixel row and the fourth pixel row respectively and the first direction ranges from 1 degree to 15 degrees, and an angle between a line connecting centers of one of the second sub-pixels and one of the third sub-pixels adjacent to each other in the second direction and the second direction ranges from 1 degree to 15 degrees.

For example, in the pixel arrangement structure provided by an embodiment of the present disclosure, the angle between the line connecting the centers of the one of the second sub-pixels and the one of the third sub-pixels adjacent to each other and located in the second pixel row and the fourth pixel row respectively and the first direction ranges from 1 degree to 3 degrees, and the angle between the line connecting the centers of the one of the second sub-pixels and the one of the third sub-pixels adjacent to each other in the second direction and the second direction ranges from 5 degrees to 7 degrees.

For example, in the pixel arrangement structure provided by an embodiment of the present disclosure, a shape of each of the second sub-pixels comprises at least one of a first shape, a second shape and a third shape, the first shape comprises a first corner part and a second corner part arranged oppositely, a distance between a vertex of the first corner part and a geometric center of a corresponding second sub-pixel is greater than a distance between a vertex of the second corner part and the geometric center of the corresponding second sub-pixel, the second shape comprises a third corner part and a flattened part arranged oppositely, and an edge of the flattened part away from the third corner part is a straight line, the third shape comprises a fourth corner part and a fifth corner part oppositely arranged in the first direction and a sixth corner part and a seventh corner part arranged oppositely in the second direction, a distance between a vertex of the fourth corner part and a geometric center of the corresponding second sub-pixel is greater than a distance between a vertex of the fifth corner part and the geometric center of the corresponding second sub-pixel, a distance between a vertex of the sixth corner part and the geometric center of the corresponding second sub-pixel is greater than a distance between a vertex of the seventh corner part and the geometric center of the corresponding second sub-pixel, and the fifth corner part and the seventh corner part are arranged adjacently.

For example, in the pixel arrangement structure provided by an embodiment of the present disclosure, a shape of each of the second sub-pixels in the second pixel row is different from a shape of each of the second sub-pixels in the fourth pixel row.

For example, in the pixel arrangement structure provided by an embodiment of the present disclosure, a virtual square is formed by lines sequentially connecting centers of two adjacent second sub-pixels in the second pixel row and centers of two adjacent second sub-pixels in the fourth pixel row.

For example, in the pixel arrangement structure provided by an embodiment of the present disclosure, a virtual quadrilateral is formed by lines sequentially connecting centers of two adjacent third sub-pixels in the second pixel row and centers of two adjacent third sub-pixels in the fourth pixel row.

For example, in the pixel arrangement structure provided by an embodiment of the present disclosure, a virtual quadrilateral is formed by lines sequentially connecting centers of two adjacent third sub-pixels in the second pixel row and centers of two adjacent third sub-pixels in the fourth pixel row.

For example, in the pixel arrangement structure provided by an embodiment of the present disclosure, at least one of a virtual isosceles trapezoid, a virtual square, and a virtual parallelogram is formed by lines sequentially connecting centers of two adjacent second sub-pixels in the second pixel row and centers of two adjacent second sub-pixels in the fourth pixel row.

For example, in the pixel arrangement structure provided by an embodiment of the present disclosure, each of the first sub-pixels is located within a range of a virtual trapezoid formed by lines sequentially connecting the centers of two adjacent second sub-pixels and the centers of two adjacent third sub-pixels.

At least one embodiment of the present disclosure further provides a pixel arrangement structure, which includes first sub-pixels, second sub-pixels and third sub-pixels, wherein a plurality of the first sub-pixels are arranged along a first direction to form a first type pixel row, a plurality of the second sub-pixels and a plurality of the third sub-pixels are arranged along the first direction and are alternately arranged, to form a second type pixel row; a plurality of first type pixel rows and a plurality of second type pixel rows are arranged along a second direction intersecting the first direction, lines sequentially connecting centers of four of the first sub-pixels surrounding one of the third sub-pixels form a virtual isosceles trapezoid, and lines sequentially connecting centers of four of the second sub-pixels surrounding the one of the third sub-pixels form a virtual quadrilateral.

For example, in the pixel arrangement structure provided by an embodiment of the present disclosure, the center of the one of the third sub-pixels is located at an intersection of diagonals of the virtual isosceles trapezoid, and the lines sequentially connecting the centers of the four of the second sub-pixels surrounding the one of the third sub-pixels form a virtual isosceles trapezoid.

For example, in the pixel arrangement structure provided by an embodiment of the present disclosure, the center of the one of the third sub-pixels is not located at an intersection of diagonals of the virtual isosceles trapezoid, and the lines sequentially connecting the centers of the four of the second sub-pixels surrounding the one of the third sub-pixels form a virtual parallelogram, a virtual rectangle or a virtual square.

For example, in the pixel arrangement structure provided by an embodiment of the present disclosure, the lines sequentially connecting the centers of the four of the second sub-pixels surrounding the one of the third sub-pixels form the virtual rectangle.

For example, in the pixel arrangement structure provided by an embodiment of the present disclosure, a center of at least one of the third sub-pixels is located at an intersection of diagonals of a virtual rectangle formed by lines sequentially connecting centers of four of the third sub-pixels surrounding the at least one of the third sub-pixels, and a center of at least one of the third sub-pixels is not located at an intersection of diagonals of a virtual rectangle formed by lines sequentially connecting centers of four of the third sub-pixels surrounding the at least one of the third sub-pixels.

For example, in the pixel arrangement structure provided by an embodiment of the present disclosure, a plurality of the third sub-pixels adjacent in the second direction are arranged at intervals according to third intervals and fourth intervals along the second direction, and sizes of the third intervals in the second direction are smaller than sizes of the fourth intervals in the second direction.

At least one embodiment of the present disclosure provides a display device, which includes any one of the abovementioned pixel arrangement structures.

### BRIEF DESCRIPTION OF DRAWINGS

In order to clearly illustrate the technical solution of the embodiments of the present disclosure, the drawings of the embodiments will be briefly described. It is obvious that the described drawings in the following are only related to some embodiments of the present disclosure and thus are not construed as any limitation to the present disclosure.
Fig. 1 is a schematic diagram of a pixel arrangement structure;
Fig. 2 is a planar schematic diagram of a display substrate provided by an embodiment of the present disclosure;
Fig. 3 is a schematic diagram of a distribution of brightness centers of virtual pixels on a display substrate provided by an embodiment of the present disclosure;
Fig. 4 is a planar schematic diagram of another display substrate provided by an embodiment of the present disclosure;
Fig. 5 is a planar schematic diagram of still another display substrate provided by an embodiment of the present disclosure;
Fig. 6 is a planar schematic diagram of still another display substrate provided by an embodiment of the present disclosure;
Fig. 7 is a schematic diagram of brightness centers of a virtual pixel of a display substrate provided by an embodiment of the present disclosure;
Fig. 8 is a planar schematic diagram of still another display substrate provided by an embodiment of the present disclosure;
Fig. 9 is a planar schematic diagram of still another display substrate provided by an embodiment of the present disclosure;
Fig. 10 is a planar schematic diagram of still another display substrate provided by an embodiment of the present disclosure;
Fig. 11 is a schematic diagram of a distribution of brightness centers of virtual pixels of another display substrate provided by an embodiment of the present disclosure;
Fig. 12 is a planar schematic diagram of still another display substrate provided by an embodiment of the present disclosure;
Fig. 13 is a planar schematic diagram of still another display substrate provided by an embodiment of the present disclosure;
Fig. 14 is a planar schematic diagram of still another display substrate provided by an embodiment of the present disclosure;
Fig. 15 is a planar schematic diagram of still another display substrate provided by an embodiment of the present disclosure;
Fig. 16 is a planar schematic diagram of still another display substrate provided by an embodiment of the present disclosure;
Fig. 17 is a planar schematic diagram of still another display substrate provided by an embodiment of the present disclosure;
Fig. 18 is a schematic diagram of three shapes of a second sub-pixel provided by an embodiment of the present disclosure;
Fig. 19 is a planar schematic diagram of still another display substrate provided by an embodiment of the present disclosure;
Fig. 20 is a s planar schematic diagram of still another display substrate provided by an embodiment of the present disclosure;
Fig. 21 is a planar schematic diagram of still another display substrate provided by an embodiment of the present disclosure;
Fig. 22 is a planar schematic diagram of still another display substrate provided by an embodiment of the present disclosure;
Fig. 23 is a schematic diagram of a display device provided by an embodiment of the present disclosure;
Fig. 24 is a planar schematic diagram of another sub-pixel provided by an embodiment of the present disclosure;
Fig. 25 is a planar schematic diagram of still another sub-pixel provided by an embodiment of the present disclosure;
Fig. 26A is a planar schematic diagram of still another sub-pixel provided by an embodiment of the present disclosure;
Fig. 26B is a planar schematic diagram of still another sub-pixel provided by an embodiment of the present disclosure;
Fig. 27 is a planar schematic diagram of still another sub-pixel provided by an embodiment of the present disclosure; and
Fig. 28 is a planar schematic diagram of still another sub-pixel provided by an embodiment of the present disclosure.

### DETAILED DESCRIPTION

In order to make objectives, technical details, and advantages of the embodiments of the present disclosure more clear, the technical solutions of the embodiments will be described in a clearly and fully understandable way in connection with the drawings related to the embodiments of the present disclosure. Apparently, the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first", "second", etc., which are used in the present disclosure, are not intended to indicate any sequence, amount or importance, but distinguish various components. Also, the terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly.

In order to improve resolution of organic light-emitting diode display devices, at present, a commonly used method is to use sub-pixel rendering (SPR) technology to make different pixels share at least one sub-pixel, thus higher resolutions are achieved with relatively few sub-pixel simulations.

In the field of organic light-emitting diode displays, the human eye has different resolution capabilities for red sub-pixels, green sub-pixels and blue sub-pixels; brightness effects of these three sub-pixels are also different, in which the green sub-pixels have the largest brightness effect, followed by the red sub-pixels, and the blue sub-pixels have the smallest brightness effect. At the same time, organic light-emitting materials used in organic light-emitting layers of sub-pixels with different colors also have different lifespans. Therefore, in an organic light-emitting diode display device, an area of a blue sub-pixel is larger than an area of a green sub-pixel, and the area of the green sub-pixel is larger than an area of a red sub-pixel.

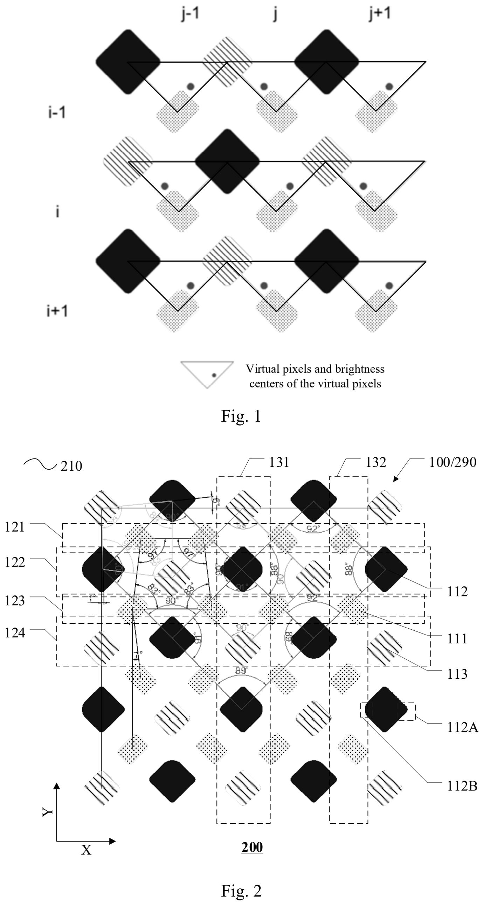

However, in a usual pixel arrangement structure, brightness centers of virtual pixels are usually arranged unevenly, thus the display quality is affected. Fig. 1 is a schematic diagram of a pixel arrangement structure. As illustrated by Fig. 1, the pixel arrangement structure includes red sub-pixels, green sub-pixels and blue sub-pixels; the green sub-pixels are arranged along the first direction to form a plurality of green sub-pixel rows, the red sub-pixels and the blue sub-pixels are alternately arranged along the first direction to form red-blue sub-pixel rows, the green sub-pixel rows and the red-blue sub-pixel rows are alternately arranged along a second direction perpendicular to the first direction. In the pixel arrangement structure, although the red sub-pixels, the green sub-pixels and the blue sub-pixels are all evenly arranged, due to the different resolution and sensitivity of the human eye to the red sub-pixels, the green sub-pixels and the blue sub-pixels, brightness centers of virtual pixels are not evenly arranged in the human eye. For example, in a virtual pixel, the brightness center of the pixel is between a green sub-pixel and a red sub-pixel, and is close to the green sub-pixel; a distance between a brightness center of a virtual pixel in the j-th column and a brightness center of a virtual pixel in the (j+1)-th column is greater than a distance between the brightness center of the virtual pixel in the j-th column and a brightness center of a virtual pixel in the (j-1)-th column; furthermore, a brightness center of a virtual pixel in the i-th row is misaligned with a brightness center of a virtual pixel in the (i+1)-th row. Therefore, in a case that a display device with the above-mentioned pixel arrangement structure and low resolution displays vertical lines or an image dominated by vertical lines, the human eye produces noticeable "distortion" and "graininess". Therefore, in an organic light-emitting diode display device, a relative uniformity of a physical spatial arrangement of the sub-pixels is not completely equivalent to a uniformity of their image display.

In this regard, embodiments of the present disclosure provide a pixel arrangement structure, which includes at least one array unit; the at least one array unit includes a first pixel row, a second pixel row, a third pixel row and a fourth pixel row; the first pixel row includes a plurality of first sub-pixels arranged along the first direction; the second pixel row includes a plurality of second sub-pixels and a plurality of third sub-pixels, which are arranged along the first direction and are alternately arranged; the third pixel row includes a plurality of first sub-pixels arranged along the first direction; the fourth pixel row includes a plurality of second sub-pixels and a plurality of third sub-pixels, which are arranged along the first direction and are alternately arranged; the first pixel row, the second pixel row, the third pixel row and the fourth pixel row are arranged along a second direction intersecting the first direction, and a virtual isosceles trapezoid is formed by lines sequentially connecting centers of two adjacent first sub-pixels in the first pixel row and centers of two adjacent first sub-pixels in the third pixel row. In this way, the pixel arrangement structure can be modulated by modulating positions of sub-pixels of different colors, so that the distribution of virtual pixels (or white point pixels) can be made more uniform, thus display problems such as "distortion" and "graininess" caused by the human eye can be solved, and a better display effect can be achieved.

At least one embodiment of the present disclosure further provides a display device, which includes the above-mentioned pixel arrangement structure. In this way, the display device can also make the distribution of virtual pixels (or white point pixels) more uniform, thus the display problems such as "distortion" and "graininess" caused by the human eye can be solved, and a better display effect can be achieved.

Hereinafter, the pixel arrangement structures and the display devices provided by the embodiments of the present disclosure will be described in detail with reference to the accompanying drawings.

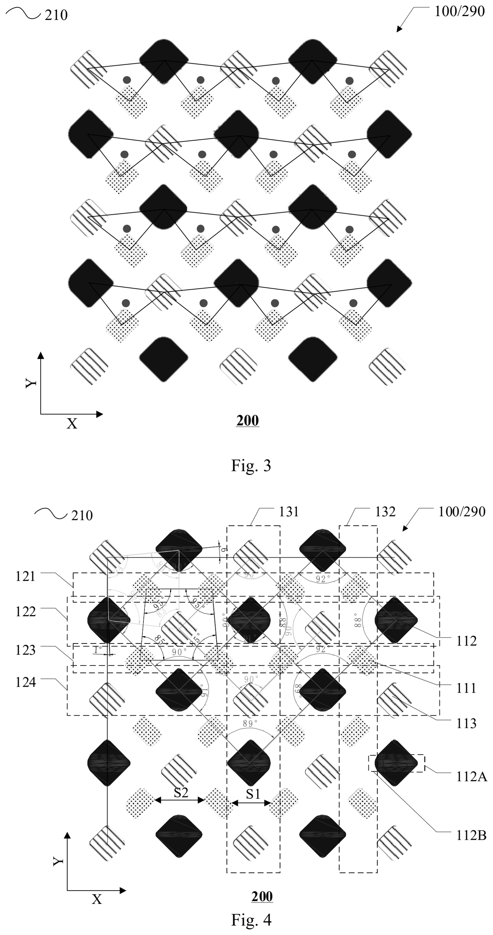

Embodiments of the present disclosure provide a display substrate. Fig. 2 is a planar schematic diagram of a display substrate provided by an embodiment of the present disclosure; and Fig. 3 is a schematic diagram of a distribution of brightness centers of virtual pixels on a display substrate provided by an embodiment of the present disclosure. As illustrated by Fig. 2, the display substrate 200 includes a base substrate 210 and a pixel arrangement structure 100 located on the base substrate 210. Therefore, embodiments of the present disclosure further provide a pixel arrangement structure 100.

As illustrated by Fig. 2, the pixel arrangement structure 100 includes at least one array unit 290; the array unit 290 includes a first pixel row 121, a second pixel row 122, a third pixel row 123 and a fourth pixel row 124; the first pixel row 121 includes a plurality of first sub-pixels 111 arranged along a first direction X; the second pixel row 122 includes a plurality of second sub-pixels 112 and a plurality of third sub-pixels 113 that are arranged along the first direction X and are alternately arranged; the third pixel row 123 includes a plurality of first sub-pixels 111 arranged along the first direction X; the fourth pixel row 124 includes a plurality of second sub-pixels 112 and a plurality of third sub-pixels 113 that are arranged along the first direction X and are alternately arranged. It should be noted that the above-mentioned first sub-pixels are sub-pixels that emit light of a first color, the above-mentioned second sub-pixels are sub-pixels that emit light of a second color, and the above-mentioned third sub-pixels are sub-pixels that emit light of a third color.

As illustrated by Fig. 2, the first pixel row 121, the second pixel row 122, the third pixel row 123 and the fourth pixel row 124 are arranged along a second direction Y that intersects with the first direction X, and a virtual isosceles trapezoid is formed by lines sequentially connecting centers of two adjacent first sub-pixels 111 in the first pixel row 121 and centers of two adjacent first sub-pixels 111 in the third pixel row 123.

In the pixel arrangement structure provided by the embodiment of the present disclosure, as illustrated by Fig. 3, the lines sequentially connecting the centers of the two adjacent first sub-pixels 111 in the first pixel row 121 and the centers of the two adjacent first sub-pixels 111 in the third pixel row 123 form the virtual isosceles trapezoid, rather than a rectangle or a square. In this way, the pixel arrangement structure can be modulated by modulating the positions of the sub-pixels of different colors, so that the distribution of the virtual pixels (or white point pixels) can be made more uniform, thus the display problems such as "distortion" and "graininess" caused by the human eye can be solved, and a better display effect can be achieved.

For example, the first direction X and the second direction Y may be perpendicular to each other. Of course, embodiments of the present disclosure include but are not limited thereto, and the first direction X and the second direction Y may not be perpendicular to each other.

For example, the above-mentioned array unit can be a smallest repeating unit of the pixel arrangement structure, the array unit can cover the entire display substrate by being repeatedly arranged in the first direction and the second direction. Of course, the embodiments of the present disclosure include but are not limited thereto, the above-mentioned array unit may also be larger than the smallest repeating unit, or smaller than the smallest repeating unit.

For example, as illustrated by Fig. 2, the smallest repeating unit of the pixel arrangement structure 100 may include 16 first sub-pixels, 8 second sub-pixels and 8 third sub-pixels.

In some examples, as illustrated by Fig. 2, the first sub-pixels 111 are configured to emit green light, the second sub-pixels 112 are configured to emit blue light, and the third sub-pixels 113 are configured to emit red light.

In some examples, as illustrated by Fig. 2, a base angle of the virtual isosceles trapezoid formed by the lines sequentially connecting the centers of the two adjacent first sub-pixels 111 in the first pixel row 121 and the centers of the two adjacent first sub-pixels 111 in the third pixel row 123 ranges from 75 degrees to 90 degrees. In this way, the pixel arrangement structure can make the distribution of the brightness centers of the virtual pixels formed by the first sub-pixels, the second sub-pixels and the third sub-pixels more uniform, thus the display problems such as "distortion" and "graininess" caused by the human eye can be better solved.

For example, as illustrated by Fig. 2, the base angle of the virtual isosceles trapezoid formed by the lines sequentially connecting the centers of the two adjacent first sub-pixels 111 in the first pixel row 121 and the centers of the two adjacent first sub-pixels 111 in the third pixel row 123 ranges from 82 degrees to 84 degrees, for example, 83 degrees. In this way, the pixel arrangement structure can make the distribution of the brightness centers of the virtual pixels formed by the first sub-pixels, the second sub-pixels and the third sub-pixels more uniform.

In some examples, as illustrated by Fig. 2, a virtual rectangle is formed by lines sequentially connecting the centers of the two adjacent third sub-pixels 113 in the second pixel row 122 and the centers of the two adjacent third sub-pixels 113 in the fourth pixel row 124. In this way, the third sub-pixels of the pixel arrangement structure are relatively uniform in the physical spatial arrangement, and only needs to modulate the positions of the first sub-pixels and the second sub-pixels, and the distribution of the brightness centers of the virtual pixels formed by the first sub-pixels, the second sub-pixels and the third sub-pixels is more uniform.

In some examples, as illustrated by Fig. 2, a virtual square is formed by lines sequentially connecting the centers of the two adjacent third sub-pixels 113 in the second pixel row 122 and the centers of the two adjacent third sub-pixels 113 in the fourth pixel row 124. In this way, the third sub-pixels of the pixel arrangement structure have a more uniform physical spatial arrangement.

In some examples, as illustrated by Fig. 2, at least one of a virtual isosceles trapezoid, a virtual square, and a virtual quadrilateral is formed by the lines sequentially connecting the centers of the two adjacent second sub-pixels 112 in the second pixel row 122 and the centers of the two adjacent second sub-pixels 112 in the fourth pixel row 124. That is, a shape formed by the lines sequentially connecting the centers of the two adjacent second sub-pixels 112 in the second pixel row 122 and the centers of the two adjacent second sub-pixels 112 in the fourth pixel row 124 may be at least one of an isosceles trapezoid, a square, and a quadrilateral. In this way, the pixel arrangement modulates the positions of the first sub-pixels and the second sub-pixels, so that the distribution of the brightness center of the virtual pixel formed by the first sub-pixels, the second sub-pixels and the third sub-pixels is more uniform.

For example, as illustrated by Fig. 2, three shapes can be formed by the lines sequentially connecting the centers of the two adjacent second sub-pixels 112 in the second pixel row 122 and the centers of the two adjacent second sub-pixels 112 in the fourth pixel row 124, and the three shapes include an isosceles trapezoid, a square and a quadrilateral; a base angle of the isosceles trapezoid is 89 degrees, and a vertex angle of the isosceles trapezoid is 91 degrees, four interior angles of the quadrilateral are 88 degrees, 92 degrees, 88 degrees and 92 degrees respectively, that is, the virtual quadrilateral can be a virtual parallelogram.

In some examples, as illustrated by Fig. 2, a shape of each of the second sub-pixels 112 includes a first corner part 112A and a second corner part 112B that are oppositely arranged, a distance between a vertex of the first corner part 112A and a geometric center of a corresponding second sub-pixel 112 is greater than a distance between a vertex of the second corner part 112B and the geometric center of the corresponding second sub-pixel 112. That is, the shape of each of the second sub-pixels 112 is not an axially symmetrical shape. In this way, the pixel arrangement structure makes an edge of the second corner part more rounded, thus occurrence of color separation can be reduced or even avoided. In addition, the pixel arrangement structure can also be configured by arranging a second sub-pixel having the above-mentioned first corner part and the above-mentioned second corner part, sizes and distances of different sub-pixels can be flexibly adjusted to achieve a better display effect. It should be noted that the above-mentioned color indicators may be parameters such as brightness, color gamut, color temperature, and wavelength of light emitted by the sub-pixels.

It is worth noting that although only the second sub-pixels in the pixel arrangement structure 100 shown in Fig. 2 have the above-mentioned asymmetric design or orientation design, embodiments of the present disclosure include but are not limited thereto, both the first sub-pixels and the third sub-pixels may adopt the above-mentioned asymmetric design or orientation design. In addition, the geometric centers of the above-mentioned sub-pixels may allow a certain error or a certain range; for example, the geometric centers of the sub-pixels may be a range with a radius of 3 µm from the geometric centers of the sub-pixels.

In some examples, as illustrated by Fig. 2, a curvature of a curve where the vertex of the first corner part 112A is located is greater than a curvature of a curve where the vertex of the second corner part 112B is located. In this way, the pixel arrangement structure can make the edge of the second corner more rounded, thus the occurrence of color separation can be reduced or even avoided.

In some examples, as illustrated by Fig. 2, an arc length of an outer edge of the first corner part 112A is smaller than an arc length of an outer edge of the second corner part 112B.

In some examples, as illustrated by Fig. 2, in the second pixel row 122 and the fourth pixel row 124, arrangement orders of the first corner part 112A and the second corner part 112B of the two adjacent second sub-pixels 112 are different, for example, the arrangement orders are opposite. In this way, the pixel arrangement structure can make an orientation distribution of the second sub-pixels in the first direction relatively uniform, thus display defects can be avoided. It should be noted that the above-mentioned orientation refers to the arrangement direction or the arrangement order of the first corner part and the second corner part.

In some examples, as illustrated by Fig. 2, arrangement orders of the first corner part 112A and the second corner part 112B of the two adjacent second sub-pixels 112 in the second direction are different, for example, the arrangement orders are opposite. In this way, the pixel arrangement structure can make the orientation distribution of the second sub-pixels in the first direction and the second direction relatively uniform, thus the display quality can be improved.

In some examples, as illustrated by Fig. 2, each of the first sub-pixels 111 is located within a range of the virtual quadrilateral formed by the lines sequentially connecting the centers of the two adjacent second sub-pixels 112 and the centers of the two adjacent third sub-pixels 113. That is, each of the first sub-pixels 111 is surrounded by the two adjacent second sub-pixels 112 and the two adjacent third sub-pixels 113. In this way, the pixel arrangement structure can better realize pixel borrowing and achieve higher display quality.

In some examples, as illustrated by Fig. 2, a first distance L1 and a second distance L2 are provided between the first sub-pixel 111 and the two second sub-pixels 112 for forming the virtual quadrilateral respectively, a third distance L3 and a fourth distance L4 are provided between the first sub-pixel 111 and the two third sub-pixels 113 for forming the virtual quadrilateral respectively; and at least two of the first distance L1, the second distance L2, the third distance L3 and the fourth distance L4 are equal. In this way, the pixel arrangement structure can fully utilize process accuracy and improve an aperture ratio of each of the sub-pixels.

In some examples, as illustrated by Fig. 2, the first distance L1, the second distance L2, the third distance L3, and the fourth distance L4 are all equal, that is, L1=L2=L3=L4.

In some examples, as illustrated by Fig. 2, the first distance L1 and the second distance L2 are equal, and the third distance L3 and the fourth distance L4 are not equal, that is, L1=L2 and L3#L4.

Of course, embodiments of the present disclosure include but are not limited thereto, and the first distance L1, the second distance L2, the third distance L3, and the fourth distance L4 mentioned above may also be unequal.

In some examples, the geometric center of the first sub-pixel 111 is not located at the geometric center of the virtual quadrilateral formed by the lines sequentially connecting the centers of the two adjacent second sub-pixels 112 and the centers of the two adjacent third sub-pixels 113.

In some examples, as illustrated by Fig. 2, the plurality of second sub-pixels 112 and the plurality of third sub-pixels 113 are alternately arranged along the second direction Y to form a first pixel column 131; in the first pixel column 131, the angle between the line connecting the centers of one of the second sub-pixels 112 and one of the third sub-pixels 113 adjacent to each other and the second direction ranges from 1 degree to 15 degrees. In this way, the pixel arrangement structure can make the distribution of virtual pixels (or white point pixels) in the first direction more uniform, thus the display problems such as "distortion" and "graininess" caused by the human eye can be solved, and a better display effect can be achieved.

In some examples, as illustrated by Fig. 2, in first pixel column 131, the angle between the line connecting the centers of one of the second sub-pixels 112 and one of the third sub-pixels 113 adjacent to each other and the second direction ranges from 5 degrees to 7 degrees. In this way, the pixel arrangement structure can further make the distribution of the virtual pixels (or white point pixels) in the first direction more uniform, thus the display problems such as "distortion" and "graininess" caused by the human eye can be solved, and a better display effect can be achieved.

In some examples, as illustrated by Fig. 2, the plurality of first sub-pixels 111 are arranged along the second direction Y to form a second pixel column 132; in the second pixel column 132, an angle between a line connecting the centers of the two adjacent first sub-pixels 111 and the second direction ranges from 1 degree to 15 degrees. In this way, the pixel arrangement structure can make the distribution of the virtual pixels (or white point pixels) in the first direction more uniform, thus the display problems such as "distortion" and "graininess" caused by the human eye can be solved, and a better display effect can be achieved.

In some examples, as illustrated by Fig. 2, the plurality of first sub-pixels 111 are arranged along the second direction Y to form a second pixel column 132; in the second pixel column 132, the angle between the line connecting the centers of the two adjacent first sub-pixels 111 and the second direction ranges from 6 degrees to 8 degrees. In this way, the pixel arrangement structure can further make the distribution of the virtual pixels (or white point pixels) in the first direction more uniform, thus the display problems such as "distortion" and "graininess" caused by the human eye can be solved, and a better display effect can be achieved.

It should be noted that the shape of each of the sub-pixels may be defined by an opening in a pixel definition layer of the corresponding sub-pixel, then the shape of each of the sub-pixels is substantially the same as a shape of the corresponding opening of the pixel definition layer. In addition, each of the sub-pixels includes a first electrode, a pixel definition layer, a light-emitting layer and a second electrode that are stacked, in a case that the light-emitting layer is formed in the opening in the above-mentioned pixel definition layer, the first electrode and the second electrode located on two sides of the light-emitting layer can drive the light-emitting layer in the opening of the pixel definition layer to emit light. For example, a functional layer is further arranged between at least one of the positions that between the light-emitting layer and the first electrode and between the light-emitting layer and the second electrode. For example, the functional layer includes any one or more layers of a hole injection layer, a hole transport layer, an electron transport layer, a hole blocking layer, an electron blocking layer, an electron injection layer, an auxiliary light-emitting layer, an interface improvement layer, and an antireflection layer.

In some examples, as illustrated by Fig. 2, the pixel arrangement structure 100 includes the first sub-pixels 111, the second sub-pixels 112 and the third sub-pixels 113, which are configured to emit light of different colors; the plurality of first sub-pixels 111 are arranged along the first direction to form a first type pixel row 121 or 123, the plurality of second sub-pixels 112 and the plurality of third sub-pixels 113 are arranged along the first direction and alternately arranged to form a second type pixel row 122 or 124; the plurality of first type pixel rows and the plurality of second type pixel rows are arranged along the second direction intersecting the first direction, lines sequentially connecting centers of four first sub-pixels 111 that surround the corresponding third sub-pixel 113 forms a virtual isosceles trapezoid, and the lines sequentially connecting the centers of the four second sub-pixels 112 that surround the corresponding third sub-pixel 113 form a virtual quadrilateral.

In the pixel arrangement structure, the lines sequentially connecting the centers of the four first sub-pixels surrounding the corresponding third sub-pixel form a virtual isosceles trapezoid, the lines sequentially connecting the centers of the four second sub-pixels surrounding the corresponding third sub-pixel form a virtual quadrilateral. In this way, the pixel arrangement structure can be modulated by modulating the positions of the sub-pixels of different colors, so that the distribution of the virtual pixels (or white point pixels) can be made more uniform, thus the display problems such as "distortion" and "graininess" caused by the human eye can be solved, and a better display effect can be achieved.

For example, the first direction X and the second direction Y may be perpendicular to each other. Of course, the embodiments of the present disclosure include but are not limited thereto, and the first direction X and the second direction Y may not be perpendicular to each other.

In some examples, as illustrated by Fig. 2, in a case that the center of the third sub-pixel 113 is located at an intersection of diagonals of the virtual isosceles trapezoid, the lines sequentially connecting the centers of the four second sub-pixels 112 surrounding the corresponding third sub-pixel 113 form a virtual isosceles trapezoid; in a case that the center of the third sub-pixel 113 is not located at the intersection of the diagonals of the virtual isosceles trapezoid, the lines sequentially connecting the centers of the four second sub-pixels 112 surrounding the corresponding third sub-pixel 113 form a virtual parallelogram, a virtual rectangle or a virtual square.

In some examples, as illustrated by Fig. 2, the lines sequentially connecting the centers of the four third sub-pixels 113 surrounding the corresponding third sub-pixel 113 form a virtual rectangle.

In some examples, as illustrated by Fig. 2, the arrangement positions of the plurality of third sub-pixels 113 have at least the following two cases: in the first case, the center of the third sub-pixel 113 is located at the intersection of the diagonals of the virtual rectangle formed by the lines sequentially connecting the centers of the four third sub-pixels 113 surrounding the corresponding third sub-pixel 113, that is: the center of at least one third sub-pixel 113 is located at the intersection of the diagonals of the virtual rectangle formed by the lines sequentially connecting the centers of the four third sub-pixels 113 surrounding the corresponding third sub-pixel 113; in the second case, the center of the third sub-pixel 113 is not located at the diagonal intersection of the virtual rectangle formed by the lines sequentially connecting the centers of the four third sub-pixels 113 surrounding the corresponding third sub-pixel 113, that is, the center of the third sub-pixel 113 is not located at the diagonal intersection of the virtual rectangle formed by the lines sequentially connecting the centers of the four third sub-pixels 113 surrounding the corresponding third sub-pixel 113.

In some examples, as illustrated by Fig. 2, the plurality of third sub-pixels 113 adjacent in the second direction are arranged at third intervals and fourth intervals along the second direction, sizes of the third intervals in the second direction are smaller than sizes of the fourth intervals in the second direction.

Fig. 4 is a planar schematic diagram of another display substrate provided by an embodiment of the present disclosure. As illustrated by Fig. 4, the display substrate 200 includes a pixel arrangement structure 100. The pixel arrangement structure 100 includes at least one array unit 290; the array unit 290 includes a first pixel row 121, a second pixel row 122, a third pixel row 123 and a fourth pixel row 124; the first pixel row 121 includes a plurality of first sub-pixels 111 arranged along the first direction X; the second pixel row 122 includes a plurality of second sub-pixels 112 and a plurality of third sub-pixels 113 that are arranged along the first direction X and are alternately arranged; the third pixel row 123 includes a plurality of first sub-pixels 111 arranged along the first direction X; the fourth pixel row 124 includes a plurality of second sub-pixels 112 and a plurality of third sub-pixels 113 that are arranged along the first direction X and are alternately arranged. The first pixel row 121, the second pixel row 122, the third pixel row 123 and the fourth pixel row 124 are arranged along the second direction Y that intersects with the first direction X, a virtual isosceles trapezoid is formed by lines sequentially connecting centers of the two adjacent first sub-pixels 111 in the first pixel row 121 and centers of the two adjacent first sub-pixels 111 in the third pixel row 123.

In the pixel arrangement structure provided by the embodiment of the present disclosure, the lines sequentially connecting the centers of the two adjacent first sub-pixels in the first pixel row and the centers of the two adjacent first sub-pixels in the third pixel row form a virtual isosceles trapezoid, rather than a rectangle or a square. In this way, the pixel arrangement structure can be modulated by modulating positions of the sub-pixels of different colors, so that the distribution of the virtual pixels (or white point pixels) can be made more uniform, thus the display problems such as "distortion" and "graininess" caused by the human eye can be solved, and a better display effect can be achieved.

For example, the first direction X and the second direction Y may be perpendicular to each other. Of course, embodiments of the present disclosure include but are not limited thereto, and the first direction X and the second direction Y may not be perpendicular to each other.

For example, the above-mentioned array unit can be the smallest repeating unit of the pixel arrangement structure, the array unit can cover the entire display substrate by being repeatedly arranged in the first direction and the second direction. Of course, embodiments of the present disclosure include but are not limited thereto, and the above-mentioned array unit may also be larger than the smallest repeating unit, or smaller than the smallest repeating unit.

For example, as illustrated by Fig. 4, the smallest repeating unit of the pixel arrangement structure 100 may include 16 first sub-pixels, 8 second sub-pixels and 8 third sub-pixels.

In some examples, as illustrated by Fig. 4, the first sub-pixels 111 are configured to emit green light, the second sub-pixels 112 are configured to emit blue light, and the third sub-pixels 113 are configured to emit red light.

In some examples, as illustrated by Fig. 4, in the first pixel row 121, a plurality of first sub-pixels 111 are arranged at first intervals S1 and second intervals S2 along the first direction, the first intervals S1 are smaller than the second intervals S2, and the first intervals S1 and the second intervals S2 are arranged alternately; that is, distances among adjacent first sub-pixels 111 in the first direction are not equal, and have two interval distances: the first interval S1 and the second interval S2. In this case, in order to take full advantage of process accuracy (such as the manufacturing accuracy of fine metal masks), and increase the pixel aperture ratio, the two opposite corner parts of the two first sub-pixels 111 on two sides of the first interval can be chamfered to form a first chamfered part, thus the width of the first interval can be increased, so that a difference between the first interval and the second interval is reduced.

For example, as illustrated by Fig. 4, a curvature of an outer edge of the first chamfered part is smaller than a curvature of an outer edge of the unchamfered corner part of the first sub-pixel 111.

In some examples, as illustrated by Fig. 4, the shape of each of the first sub-pixels 111 is a strip shape, thereby each of the first sub-pixels has an extension direction; an angle between the extension direction of each of the first sub-pixels 111 and the first direction or the second direction ranges from 30 degrees to 60 degrees.

In some examples, as illustrated by Fig. 4, the extension directions of two adjacent first sub-pixels 111 in the first direction are symmetrically arranged with respect to the second direction; that is, the two adjacent first pixels in the first direction are arranged symmetrically with respect to the second direction.

In some examples, as illustrated by Fig. 4, because the first sub-pixels 111 are chamfered, the base angle of the virtual isosceles trapezoid formed by the lines sequentially connecting the centers of the two adjacent first sub-pixels 111 in the first pixel row 121 and the centers of the two adjacent first sub-pixels 111 in the third pixel row 123 ranges from 84 degrees to 86 degrees, for example, 85 degrees. In this way, the pixel arrangement structure can make the distribution of the brightness center of the virtual pixel formed by the first sub-pixels, the second sub-pixels and the third sub-pixels more uniform.

In some examples, as illustrated by Fig. 4, the shape of each of the second sub-pixels 112 includes a first corner part 112A and a second corner part 112B that are oppositely arranged, a distance between a vertex of the first corner part 112A and a geometric center of the corresponding second sub-pixel 112 is greater than a distance between a vertex of the second corner 112B and the geometric center of the corresponding second sub-pixel 112. That is, the shape of each of the second sub-pixels 112 is not an axially symmetrical shape. In this way, the pixel arrangement structure makes an edge of the second corner part more rounded, thus the occurrence of color separation can be reduced or even avoided. In addition, the pixel arrangement structure can also be configured by arranging the second sub-pixels having the first corner parts and the second corner parts mentioned above, so that the sizes and the distances of different sub-pixels can be flexibly adjusted to achieve a better display effect. It should be noted that the above-mentioned color indicators may be parameters such as brightness, color gamut, color temperature, and wavelength of light emitted by the sub-pixels.

In some examples, as illustrated by Fig. 4, a curvature of a curve where the vertex of the first corner part 112A is located is greater than a curvature of a curve where the vertex of the second corner part 112B is located. In this way, the pixel arrangement structure can make the edge of the second corner part more rounded, thus the occurrence of color separation can be reduced or even avoided.

In some examples, as illustrated by Fig. 4, in the second pixel row 122 and the fourth pixel row 124, arrangement orders of the first corner part 112A and the second corner part 112B of two adjacent second sub-pixels 112 are different, for example, the arrangement orders are opposite. In this way, the pixel arrangement structure can make the orientation distribution of the second sub-pixels in the first direction relatively uniform, thus the display defects can be avoided. It should be noted that the above-mentioned orientation refers to the arrangement direction or the order of the first corner part and the second corner part.

In some examples, as illustrated by Fig. 4, the arrangement orders of the first corner part 112A and the second corner part 112B of the two adjacent second sub-pixels 112 in the second direction are different, for example, the arrangement orders are opposite. In this way, the pixel arrangement structure can make the orientation distribution of the second sub-pixels in the first direction and the second direction relatively uniform, thus the display quality can be improved.

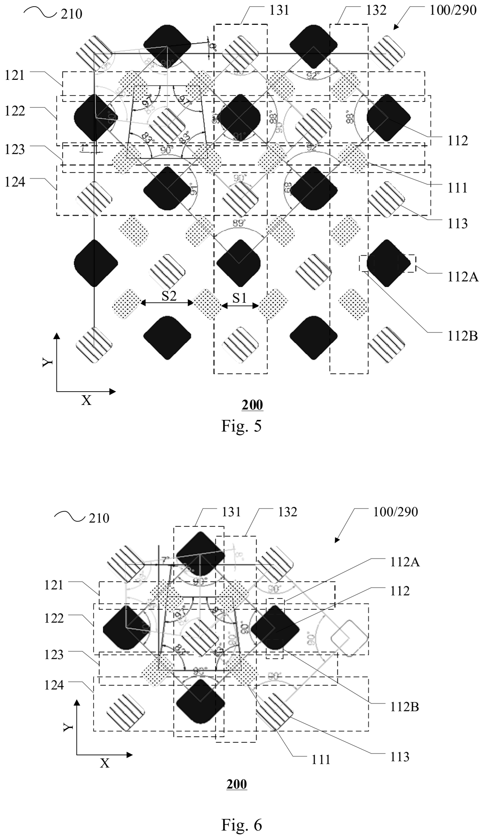

Fig. 5 is a planar schematic diagram of still another display substrate provided by an embodiment of the present disclosure. As illustrated by Fig. 5, the display substrate 200 includes a pixel arrangement structure 100. The pixel arrangement structure 100 includes at least one array unit 290; the array unit 290 includes a first pixel row 121, a second pixel row 122, a third pixel row 123 and a fourth pixel row 124; the first pixel row 121 includes a plurality of first sub-pixels 111 arranged along the first direction X; the second pixel row 122 includes a plurality of second sub-pixels 112 and a plurality of third sub-pixels 113 that are arranged along the first direction X and are alternately arranged; the third pixel row 123 includes a plurality of first sub-pixels 111 arranged along the first direction X; the fourth pixel row 124 includes a plurality of second sub-pixels 112 and a plurality of third sub-pixels 113 that are arranged along the first direction X and are alternately arranged. The first pixel row 121, the second pixel row 122, the third pixel row 123 and the fourth pixel row 124 are arranged along the second direction Y that intersects the first direction X, and lines sequentially connecting centers of two adjacent first sub-pixels 111 in the first pixel row 121 and centers of two adjacent first sub-pixels 111 in the third pixel row 123 form a virtual isosceles trapezoid.

In the pixel arrangement structure provided by the embodiment of the present disclosure, the lines sequentially connecting the centers of the two adjacent first sub-pixels in the first pixel row and the centers of the two adjacent first sub-pixels in the third pixel row form a virtual isosceles trapezoid, rather than a rectangle or a square. In this way, the pixel arrangement structure can be modulated by modulating the positions of the sub-pixels of different colors, so that the distribution of the virtual pixels (or white point pixels) can be made more uniform, thus the display problems such as "distortion" and "graininess" caused by the human eye can be solved, and a better display effect can be achieved.

For example, the first direction X and the second direction Y may be perpendicular to each other. Of course, the embodiments of the present disclosure include but are not limited thereto, and the first direction X and the second direction Y may not be perpendicular to each other.

For example, the above-mentioned array unit can be the smallest repeating unit of the pixel arrangement structure, the array unit can cover the entire display substrate by being repeatedly arranged in the first direction and the second direction. Of course, the embodiments of the present disclosure include but are not limited thereto, and the above-mentioned array unit may also be larger than the smallest repeating unit, or smaller than the smallest repeating unit.

In some examples, as illustrated by Fig. 5, the first sub-pixels 111 are configured to emit green light, the second sub-pixels 112 are configured to emit blue light, and the third sub-pixels 113 are configured to emit red light.

In some examples, as illustrated by Fig. 5, in the first pixel row 121, the plurality of first sub-pixels 111 are arranged at intervals along the first direction according to the first interval S1 and the second interval S2, the first interval S1 is smaller than the second interval S2, and the first interval S1 and the second interval S2 are alternately arranged; that is, distances between the first sub-pixels 111 adjacent in the first direction are different, and have two interval distances: the first interval S1 and the second interval S2. In this case, in order to make full use of process accuracy (such as the manufacturing accuracy of the fine metal masks), and improve the pixel aperture ratio, two opposite corner parts of the two first sub-pixels 111 on two sides of the first interval may be chamfered to form the first chamfered part.

For example, as illustrated by Fig. 5, a curvature of an outer edge of the first chamfered part is smaller than a curvature of an outer edge of the unchamfered corner part of the first sub-pixel 111.

In some examples, as illustrated by Fig. 5, two opposite corner parts of the two first sub-pixels 111 on two sides of the second interval S2 may also be chamfered to form a second chamfered part. In this way, the pixel arrangement structure can further make full use of the process accuracy (such as the manufacturing accuracy of fine metal masks), and can improve the pixel aperture ratio. In addition, the shape of each of the first sub-pixels is also more symmetrical.

For example, as illustrated by Fig. 5, a curvature of an outer edge of the second chamfered part is smaller than the curvature of the outer edge of the unchamfered corner part of the first sub-pixel 111.

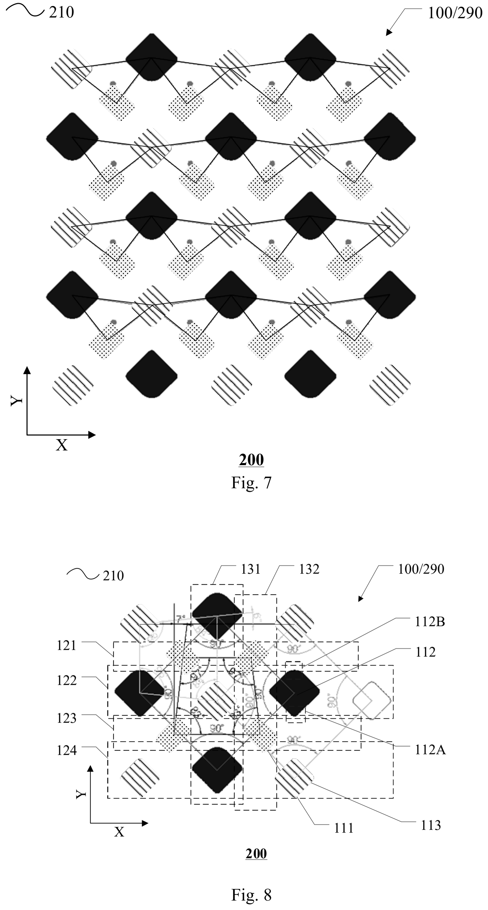

Fig. 6 is a planar schematic diagram of still another display substrate provided by an embodiment of the present disclosure; and Fig. 7 is a schematic diagram of brightness centers of a virtual pixel of a display substrate provided by an embodiment of the present disclosure. As illustrated by Fig. 6, the display substrate 200 includes a pixel arrangement structure 100. The pixel arrangement structure 100 includes at least one array unit 290; the array unit 290 includes a first pixel row 121, a second pixel row 122, a third pixel row 123 and a fourth pixel row 124; the first pixel row 121 includes a plurality of first sub-pixels 111 arranged along the first direction X; the second pixel row 122 includes a plurality of second sub-pixels 112 and a plurality of third sub-pixels 113 that are arranged along the first direction X and are alternately arranged; the third pixel row 123 includes a plurality of first sub-pixels 111 arranged along the first direction X; and the fourth pixel row 124 includes a plurality of second sub-pixels 112 and a plurality of third sub-pixels 113 that are arranged along the first direction X and are alternately arranged. The first pixel row 121, the second pixel row 122, the third pixel row 123 and the fourth pixel row 124 are arranged along the second direction Y that intersects the first direction X, and lines sequentially connecting centers of two adjacent first sub-pixels 111 in the first pixel row 121 and two adjacent first sub-pixels 111 in the third pixel row 123 form a virtual isosceles trapezoid.

In the pixel arrangement structure provided by the embodiment of the present disclosure, as illustrated by Fig. 7, the lines sequentially connecting the centers of the two adjacent first sub-pixels 111 in the first pixel row 121 and the centers of the two adjacent first sub-pixels 111 in the third pixel row 123 form a virtual isosceles trapezoid, rather than a rectangle or a square. In this way, the pixel arrangement structure can be modulated by modulating the positions of the sub-pixels of different colors, so that the distribution of the virtual pixels (or white point pixels) can be made more uniform, thus the display problems such as "distortion" and "graininess" caused by the human eye can be solved, and a better display effect can be achieved.

For example, the first direction X and the second direction Y may be perpendicular to each other. Of course, the embodiments of the present disclosure include but are not limited thereto, and the first direction X and the second direction Y may not be perpendicular to each other.

For example, the above-mentioned array unit can be the smallest repeating unit of the pixel arrangement structure, and the array unit can cover the entire display substrate by being repeatedly arranged in the first direction and the second direction. Of course, the embodiments of the present disclosure include but are not limited thereto, and the above-mentioned array unit may also be larger than the smallest repeating unit, or smaller than the smallest repeating unit.

In some examples, as illustrated by Fig. 6, the smallest repeating unit of the pixel arrangement structure 100 includes four first sub-pixels, two second sub-pixels and two third sub-pixels.

In some examples, as illustrated by Fig. 6, the first sub-pixels 111 are configured to emit green light, the second sub-pixels 112 are configured to emit blue light, and the third sub-pixels 113 are configured to emit red light. Of course, the embodiments of the present disclosure include but are not limited thereto, the color of the light emitted by the second sub-pixels and the color of the light emitted by the third sub-pixels can be interchanged, that is, the second sub-pixels are configured to emit red light, and the third sub-pixels are configured to emit blue light.

In some examples, as illustrated by Fig. 6, the plurality of second sub-pixels 112 and the plurality of third sub-pixels 113 are alternately arranged along the second direction Y to form a first pixel column 131.

In some examples, as illustrated by Fig. 6 , a shape of each of the second sub-pixels 112 includes a first corner part 112A and a second corner part 112B that are oppositely disposed, a distance between a vertex of the first corner part 112A and a geometric center of a corresponding second sub-pixel 112 is greater than a distance between a vertex of the second corner 112B and the geometric center of the corresponding second sub-pixel 112; in the first pixel column 131, the first corner part 112A and the second corner part 112B of the second sub-pixel 112 are arranged opposite to each other in the second direction. That is, in this pixel arrangement structure, the first corner part 112A and the second corner part 112B of the second sub-pixel 112 are arranged in the second direction, that is, the second sub-pixel 112 has an orientation in the second direction, thus the difficulty of manufacturing the corresponding mask plate can be reduced. Of course, the embodiments of the present disclosure include but are not limited thereto, and the first corner part 112A and the second corner part 112B of the second sub-pixel 112 may also be arranged oppositely in the first direction.

For example, as illustrated by Fig. 6, the first corner 112A of the second sub-pixel 112 is located above the second corner 112B of the second sub-pixel 112, that is, the second sub-pixel 112 is oriented upward.

In some examples, as illustrated by Fig. 6, a curvature of a curve where the vertex of the first corner part 112A is located is greater than a curvature of a curve where the vertex of the second corner part 112B is located. In this way, the pixel arrangement structure can make the edge of the second corner part more rounded, thus the occurrence of color separation can be reduced or even avoided.

In some examples, as illustrated by Fig. 6, a base angle of the virtual isosceles trapezoid formed by the lines sequentially connecting the centers of the two adjacent first sub-pixels 111 in the first pixel row 121 and the centers of the two adjacent first sub-pixels 111 in the third pixel row 123 ranges from 75 degrees to 90 degrees. In this way, the pixel arrangement structure can make the distribution of the brightness centers of the virtual pixels formed by the first sub-pixels, the second sub-pixels and the third sub-pixels more uniform, thus the display problems such as "distortion" and "graininess" caused by the human eye can be better solved.

For example, as illustrated by Fig. 6, the base angle of the virtual isosceles trapezoid formed by the lines sequentially connecting the centers of the two adjacent first sub-pixels 111 in the first pixel row 121 and the centers of the two adjacent first sub-pixels 111 in the third pixel row 123 ranges from 82 degrees to 84 degrees, for example, 83 degrees. In this way, the pixel arrangement structure can make the distribution of the brightness centers of the virtual pixels formed by the first sub-pixels, the second sub-pixels and the third sub-pixels more uniform.

In some examples, as illustrated by Fig. 6, the lines sequentially connecting the centers of the two adjacent third sub-pixels 113 in the second pixel row 122 and the centers of the two adjacent third sub-pixels 113 in the fourth pixel row 124 form a virtual square. In this way, the third sub-pixels of the pixel arrangement structure are relatively uniform in the physical spatial arrangement, only the positions of the first sub-pixels and the second sub-pixels need to be modulated, so that the distribution of the brightness centers of the virtual pixels formed by the first sub-pixels, the second sub-pixels and the third sub-pixels is more uniform.

In some examples, as illustrated by Fig. 6, the lines sequentially connecting the centers of the two adjacent second sub-pixels 112 in the second pixel row 122 and the centers of the two adjacent second sub-pixels 112 in the fourth pixel row 124 form a virtual square. In this way, the pixel arrangement structure only modulates the positions of the first sub-pixels, so that the distribution of the brightness centers of the virtual pixels formed by the first sub-pixels, the second sub-pixels and the third sub-pixels is more uniform.

In some examples, as illustrated by Fig. 6, in the second pixel row 122 and the fourth pixel row 124, the arrangement orders of the first corner part 112A and the second corner part 112B of the two adjacent second sub-pixels 112 are the same. The arrangement orders of the first corner part 112A and the second corner part 112B of the two second sub-pixels 112 adjacent in the second direction are the same. In this way, the pixel arrangement structure can simplify the manufacturing difficulty of the mask plate of the second sub-pixels.

In some examples, as illustrated by Fig. 6, each of the first sub-pixels 111 is located within the range of the virtual quadrilateral formed by the lines sequentially connecting the centers of the two adjacent second sub-pixels 112 and the centers of the two adjacent third sub-pixels 113. That is, each of the first sub-pixels 111 is surrounded by two adjacent second sub-pixels 112 and two adjacent third sub-pixels 113. In this way, the pixel arrangement structure can better realize pixel borrowing, and achieve higher display quality.

In some examples, as illustrated by Fig. 6, a line connecting the centers of the second sub-pixel 112 and the third sub-pixel 113 which are adjacent to each other in the second direction is parallel to the second direction.

In some examples, as illustrated by Fig. 6, in the second pixel row 122 or the fourth pixel row 124, an angle between a line connecting the centers of the second sub-pixel 112 and the third sub-pixel 113 which are adjacent to each other and the first direction ranges from 1 degree to 10 degrees. In this way, the pixel arrangement structure can further make the distribution of the virtual pixels (or white point pixels) in the second direction more uniform, thus the display problems such as "distortion" and "graininess" caused by the human eye can be solved, and a better display effect can be achieved.

In some examples, as illustrated by Fig. 6, in the second pixel row 122 or the fourth pixel row 124, the angle between the line connecting the centers of the second sub-pixel 112 and the third sub-pixel 113 which are adjacent to each other and the first direction ranges from ranges from 5 degrees to 9 degrees. In this way, the pixel arrangement structure can further make the distribution of virtual pixels (or white point pixels) in the second direction more uniform, thus the display problems such as "distortion" and "graininess" caused by the human eye can be solved, and a better display effect can be achieved.

In some examples, as illustrated by Fig. 6, in the second pixel row 122 or the fourth pixel row 124, the angle between the line connecting the centers of the second sub-pixel 112 and the third sub-pixel 113 which are adjacent to each other and the first direction ranges from 7 degrees to 9 degrees. In this way, the pixel arrangement structure can further make the distribution of the virtual pixels (or white point pixels) in the second direction more uniform, thus the display problems such as "distortion" and "graininess" caused by the human eye can be solved, and a better display effect can be achieved.

In some examples, as illustrated by Fig. 6, the plurality of first sub-pixels 111 are arranged along the second direction Y, to form a second pixel column 132; in the second pixel column 132, an angle between a line connecting centers of two adjacent first sub-pixels 111 and the second direction ranges from 1 degree to 15 degrees. In this way, the pixel arrangement structure can make the distribution of the virtual pixels (or white point pixels) in the first direction more uniform, thus the display problems such as "distortion" and "graininess" caused by the human eye can be solved, and a better display effect can be achieved.

In some examples, as illustrated by Fig. 6, the plurality of first sub-pixels 111 are arranged along the second direction Y to form a second pixel column 132; in the second pixel column 132, the angle between the line connecting the centers of the two adjacent first sub-pixels 111 and the second direction ranges from 6 degrees to 8 degrees. In this way, the pixel arrangement structure can further make the distribution of the virtual pixels (or white point pixels) in the first direction more uniform, thus the display problems such as "distortion" and "graininess" caused by the human eye can be solved, and a better display effect can be achieved.

In some examples, as illustrated by Fig. 6, a first distance L1 and a second distance L2 are provided between the first sub-pixel 111 and the two second sub-pixels 112 for forming the virtual quadrilateral respectively, a third distance L3 and a fourth distance L4 are provided between the first sub-pixel 111 and the two third sub-pixels 113 for forming the virtual quadrilateral respectively; at least two of the first distance L1, the second distance L2, the third distance L3 and the fourth distance L4 are equal. In this way, the pixel arrangement structure can make full use of process accuracy, and improve the aperture ratio of each sub-pixel.

In some examples, as illustrated by Fig. 6, the first distance L1, the second distance L2, the third distance L3 and the fourth distance L4 are all equal, that is, L1=L2=L3=L4.

In some examples, as illustrated by Fig. 6, the first distance L1 and the second distance L2 are equal, and the third distance L3 and the fourth distance L4 are not equal, that is, L1=L2 and L3#L4.

Of course, the embodiments of the present disclosure include but are not limited thereto, and the first distance L1, the second distance L2, the third distance L3, and the fourth distance L4 mentioned above may also be unequal.

In some examples, the geometric center of the first sub-pixel 111 is not located at the geometric center of the virtual quadrilateral formed by the lines sequentially connecting the centers of the two adjacent second sub-pixels 112 and the centers of the two adjacent third sub-pixels 113.

Fig. 8 is a planar schematic diagram of still another display substrate provided by an embodiment of the present disclosure. As illustrated by Fig. 8, the display substrate 200 includes a pixel arrangement structure 100. The pixel arrangement structure 100 includes at least one array unit 290; the array unit 290 includes a first pixel row 121, a second pixel row 122, a third pixel row 123 and a fourth pixel row 124; the first pixel row 121 includes a plurality of first sub-pixels 111 arranged along the first direction X; the second pixel row 122 includes a plurality of second sub-pixels 112 and a plurality of third sub-pixels 113 that are arranged along the first direction X and are alternately arranged; the third pixel row 123 includes a plurality of first sub-pixels 111 arranged along the first direction X; and the fourth pixel row 124 includes a plurality of second sub-pixels 112 and a plurality of third sub-pixels 113 that are arranged along the first direction X and are alternately arranged. The first pixel row 121, the second pixel row 122, the third pixel row 123 and the fourth pixel row 124 are arranged along the second direction Y that intersects the first direction X, and lines sequentially connecting centers of two adjacent first sub-pixels 111 in the first pixel row 121 and centers of two adjacent first sub-pixels 111 in the third pixel row 123 form a virtual isosceles trapezoid.

In the pixel arrangement structure provided by the embodiment of the present disclosure, the lines sequentially connecting the centers of the two adjacent first sub-pixels in the first pixel row and the centers of the two adjacent first sub-pixels in the third pixel row form a virtual isosceles trapezoid, rather than a rectangle or a square. In this way, the pixel arrangement structure can be modulated by modulating the positions of the sub-pixels of different colors, so that the distribution of the virtual pixels (or white point pixels) can be made more uniform, thus the display problems such as "distortion" and "graininess" caused by the human eye can be solved, and a better display effect can be achieved.

For example, the first direction X and the second direction Y may be perpendicular to each other. Of course, the embodiments of the present disclosure include but are not limited thereto, and the first direction X and the second direction Y may not be perpendicular to each other.

For example, the above-mentioned array unit can be the smallest repeating unit of the pixel arrangement structure, and the array unit can cover the entire display substrate by being repeatedly arranged in the first direction and the second direction. Of course, the embodiments of the present disclosure include but are not limited thereto, and the above-mentioned array unit may also be larger than the smallest repeating unit, or smaller than the smallest repeating unit.

In some examples, as illustrated by Fig. 8, the first sub-pixels 111 are configured to emit green light, the second sub-pixels 112 are configured to emit blue light, and the third sub-pixels 113 are configured to emit red light. Of course, the embodiments of the present disclosure include but are not limited thereto, the color of the light emitted by the second sub-pixel and the color of the light emitted by the third sub-pixel can be interchanged, that is, the second sub-pixels are configured to emit red light, and the third sub-pixels are configured to emit blue light.

In some examples, as illustrated by Fig. 8, the plurality of second sub-pixels 112 and the plurality of third sub-pixels 113 are alternately arranged along the second direction Y, to form a first pixel column 131.

In some examples, as illustrated by Fig. 8, a shape of each of the second sub-pixels 112 includes a first corner part 112A and a second corner part 112B arranged oppositely, a distance between a vertex of the first corner part 112A and a geometric center of the corresponding second sub-pixel 112 is greater than a distance between a vertex of the second corner part 112B and the geometric center of the corresponding second sub-pixel 112; in the first pixel column 131, the first corner part 112A and the second corner part 112B of the second sub-pixel 112 are arranged opposite to each other in the second direction. That is, in this pixel arrangement structure, the first corner part 112A and the second corner part 112B of the second sub-pixel 112 are arranged in the second direction, that is, the second sub-pixel 112 has an orientation in the second direction, thus the difficulty of manufacturing the corresponding mask plate can be reduced.

For example, as illustrated by Fig. 8, the first corner part 112A of the second sub-pixel 112 is located below the second corner part 112B of the second sub-pixel 112, that is, the orientation of the second sub-pixel 112 is downward.

In some examples, as illustrated by Fig. 8, in the second pixel row 122 and the fourth pixel row 124, the arrangement orders of the first corner part 112A and the second corner part 112B of two adjacent second sub-pixels 112 are the same. The arrangement order of the first corner part 112A and the second corner part 112B of the two second sub-pixels 112 adjacent in the second direction are the same. In this way, the pixel arrangement structure can simplify the manufacturing difficulty of the mask plate of the second sub-pixels.

In some examples, as illustrated by Fig. 8, each of the first sub-pixels 111 is located within a range of the virtual quadrilateral formed by the lines sequentially connecting the centers of the two adjacent second sub-pixels 112 and the centers of the two adjacent third sub-pixels 113. That is, each of the first sub-pixels 111 is surrounded by the two adjacent second sub-pixels 112 and the two third sub-pixels 113. In this way, the pixel arrangement structure can better realize pixel borrowing, and achieve higher display quality.

In some examples, as illustrated by Fig. 8, the line connecting the center of the second sub-pixel 112 and the center of the third sub-pixel 113 which are adjacent to each other in the second direction is parallel to the second direction.

In some examples, as illustrated by Fig. 8, in the second pixel row 122 or the fourth pixel row 124, an angle between a line connecting the centers of the second sub-pixel 112 and the third sub-pixel 113 that are adjacent to each other and the first direction ranges from 1 degree to 10 degrees. In this way, the pixel arrangement structure can further make the distribution of the virtual pixels (or white point pixels) in the second direction more uniform, thus the display problems such as "distortion" and "graininess" caused by the human eye can be solved, and a better display effect can be achieved.

In some examples, as illustrated by Fig. 8, in the second pixel row 122 or the fourth pixel row 124, the angle between the line connecting the centers of the second sub-pixel 112 and the third sub-pixel 113 that are adjacent to each other and the first direction ranges from 5 degrees to 7 degrees. In this way, the pixel arrangement structure can further make the distribution of the virtual pixels (or white point pixels) in the second direction more uniform, thus the display problems such as "distortion" and "graininess" caused by the human eye can be solved, and a better display effect can be achieved.

In some examples, as illustrated by Fig. 8, the plurality of first sub-pixels 111 are arranged along the second direction Y to form a second pixel column 132; in the second pixel column 132, an angle between a line connecting the centers of two adjacent first sub-pixels 111 and the second direction ranges from 1 degree to 15 degrees. In this way, the pixel arrangement structure can make the distribution of virtual pixels (or white point pixels) in the first direction more uniform, thus the display problems such as "distortion" and "graininess" caused by the human eye can be solved, and a better display effect can be achieved.

In some examples, as illustrated by Fig. 8, the plurality of first sub-pixels 111 are arranged along the second direction Y to form a second pixel column 132; in the second pixel column 132, an angle between a line connecting the centers of the two adjacent first sub-pixels 111 and the second direction ranges from 6 degrees to 8 degrees. In this way, the pixel arrangement structure can further make the distribution of the virtual pixels (or white point pixels) in the first direction more uniform, thus the display problems such as "distortion" and "graininess" caused by the human eye can be solved, and a better display effect can be achieved.

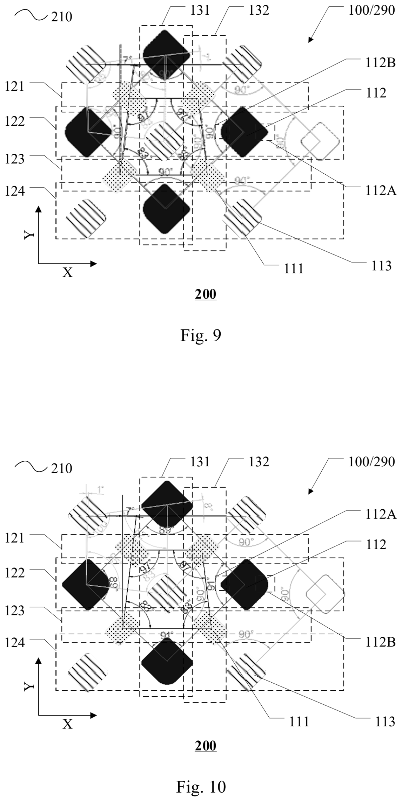

Fig. 9 is a planar schematic diagram of still another display substrate provided by an embodiment of the present disclosure. As illustrated by Fig. 9, the display substrate 200 includes a pixel arrangement structure 100. The pixel arrangement structure 100 includes at least one array unit 290; the array unit 290 includes a first pixel row 121, a second pixel row 122, a third pixel row 123 and a fourth pixel row 124; the first pixel row 121 includes a plurality of first sub-pixels 111 arranged along the first direction X; the second pixel row 122 includes a plurality of second sub-pixels 112 and a plurality of third sub-pixels 113 that are arranged along the first direction X and are alternately arranged; the third pixel row 123 includes a plurality of first sub-pixels 111 arranged along the first direction X; and the fourth pixel row 124 includes a plurality of second sub-pixels 112 and a plurality of third sub-pixels 113 that are arranged along the first direction X and are alternately arranged. The first pixel row 121, the second pixel row 122, the third pixel row 123 and the fourth pixel row 124 are arranged along the second direction Y that intersects the first direction X, and a virtual isosceles trapezoid is formed by lines sequentially connecting centers of two adjacent first sub-pixels 111 in the first pixel row 121 and centers of two adjacent first sub-pixels 111 in the third pixel row 123.

In the pixel arrangement structure provided by the embodiment of the present disclosure, the lines sequentially connecting the centers of the two adjacent first sub-pixels in the first pixel row and the centers of the two adjacent first sub-pixels in the third pixel row form a virtual isosceles trapezoid, rather than a rectangle or a square. In this way, the pixel arrangement structure can make the distribution of virtual pixels (or white point pixels) more uniform by modulating the positions of sub-pixels of different colors, thus the display problems such as "distortion" and "graininess" caused by the human eye can be solved, and a better display effect can be achieved.

For example, the first direction X and the second direction Y may be perpendicular to each other. Of course, the embodiments of the present disclosure include but are not limited thereto, and the first direction X and the second direction Y may not be perpendicular to each other.

For example, the above-mentioned array unit can be the smallest repeating unit of the pixel arrangement structure, and the array unit can cover the entire display substrate by being repeatedly arranged in the first direction and the second direction. Of course, the embodiments of the present disclosure include but are not limited thereto, and the above-mentioned array unit may also be larger than the smallest repeating unit, or smaller than the smallest repeating unit.

In some examples, as illustrated by Fig. 9, the first sub-pixels 111 are configured to emit green light, the second sub-pixels 112 are configured to emit blue light, and the third sub-pixels 113 are configured to emit red light. Of course, the embodiments of the present disclosure include but are not limited thereto, the color of the light emitted by the second sub-pixel and the color of the light emitted by the third sub-pixel can be interchanged, that is, the second sub-pixels are configured to emit red light, and the third sub-pixels are configured to emit blue light.

In some examples, as illustrated by Fig. 9, the plurality of second sub-pixels 112 and the plurality of third sub-pixels 113 are alternately arranged along the second direction Y, to form a first pixel column 131.

In some examples, as illustrated by Fig. 9, a shape of each of the second sub-pixels 112 includes a first corner part 112A and a second corner part 112B arranged oppositely, a distance between a vertex of the first corner part 112A and a geometric center of a corresponding second sub-pixel 112 is greater than a distance between a vertex of the second corner part 112B and the geometric center of the corresponding second sub-pixel 112; and in the first pixel column 131, the first corner part 112A and the second corner part 112B of the second sub-pixel 112 are arranged opposite to each other in the first direction. That is to say, in the pixel arrangement structure, the first corner part 112A and the second corner part 112B of the second sub-pixel 112 are arranged in the first direction, that is, the second sub-pixel 112 has an orientation in the first direction, thus the difficulty of manufacturing the corresponding mask can be reduced.

For example, as illustrated by Fig. 9, the first corner part 112A of the second sub-pixel 112 is located at the right side of the second corner part 112B, that is, the orientation of the second sub-pixel 112 towards the right.

In some examples, as illustrated by Fig. 9, in the second pixel row 122 and the fourth pixel row 124, the arrangement orders of the first corner part 112A and the second corner part 112B of two adjacent second sub-pixels 112 are the same. The arrangement orders of the first corner part 112A and the second corner part 112B of the two adjacent second sub-pixels 112 in the second direction are the same. In this way, the pixel arrangement structure can simplify the manufacturing difficulty of the mask plate of the second sub-pixel.

In some examples, as illustrated by Fig. 9, each of the first sub-pixels 111 is located within a range of the virtual quadrilateral formed by the lines sequentially connecting the centers of the two adjacent second sub-pixels 112 and the centers of the two adjacent third sub-pixels 113. That is to say, each of the first sub-pixels 111 is surrounded by the two adjacent second sub-pixels 112 and the two third sub-pixels 113. In this way, the pixel arrangement structure can better realize pixel borrowing, and achieve higher display quality.

In some examples, as illustrated by Fig. 9, an angle between a line connecting the centers of the second sub-pixel 112 and the third sub-pixel 113 adjacent to each other in the second direction and the second direction ranges from 1 degree to 15 degrees, for example, 1 degree.

In some examples, as illustrated by Fig. 9, in the second pixel row 122 or the fourth pixel row 124, an angle between a line connecting the second sub-pixel 112 and the third sub-pixel 113 which are adjacent to each other and the first direction ranges from 1 degree to 15 degrees. In this way, the pixel arrangement structure can further make the distribution of virtual pixels (or white point pixels) in the second direction more uniform, thus the display problems such as "distortion" and "graininess" caused by the human eye can be solved, and a better display effect can be achieved.

In some examples, as illustrated by Fig. 9, in the second pixel row 122 or the fourth pixel row 124, the angle between the line connecting the centers of the second sub-pixel 112 and the third sub-pixel 113 adjacent to each other and the first direction ranges from 6 degrees to 8 degrees. In this way, the pixel arrangement structure can further make the distribution of virtual pixels (or white point pixels) in the second direction more uniform, thus the display problems such as "distortion" and "graininess" caused by the human eye can be solved, and a better display effect can be achieved.

In some examples, as illustrated by Fig. 9, the plurality of the first sub-pixels 111 are arranged along the second direction Y to form a second pixel column 132; in the second pixel column 132, an angle between the line connecting the centers of the two adjacent first sub-pixels 111 and the second direction ranges from 1 degree to 15 degrees. In this way, the pixel arrangement structure can make the distribution of virtual pixels (or white point pixels) in the first direction more uniform, thus the display problems such as "distortion" and "graininess" caused by the human eye can be solved, and a better display effect can be achieved.

In some examples, as illustrated by Fig. 9, the plurality of first sub-pixels 111 are arranged along the second direction Y to form a second pixel column 132; in the second pixel column 132, the angle between the line connecting the centers of the two adjacent first sub-pixels 111 and the second direction ranges from 6 degrees to 8 degrees. In this way, the pixel arrangement structure can further make the distribution of virtual pixels (or white point pixels) in the first direction more uniform, thus the display problems such as "distortion" and "graininess" caused by the human eye can be solved, and a better display effect can be achieved.

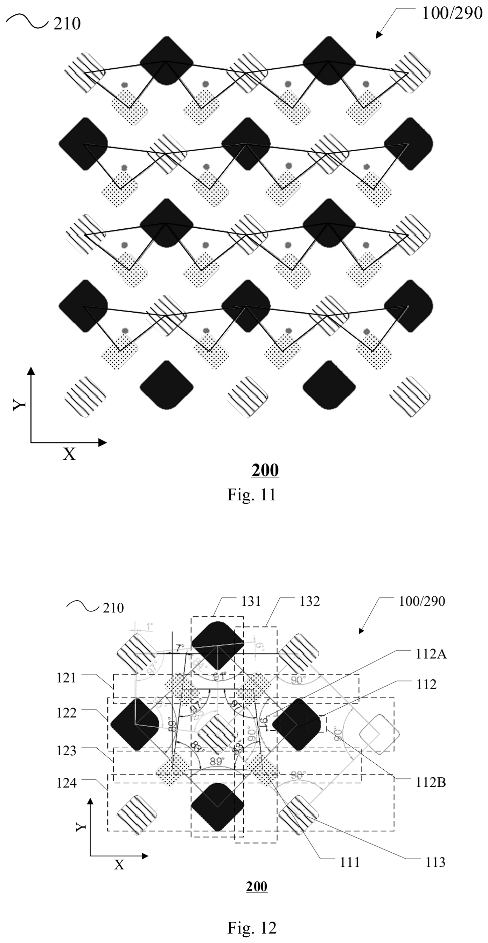

Fig. 10 is a planar schematic diagram of still another display substrate provided by an embodiment of the present disclosure; and Fig. 11 is a schematic diagram of a distribution of brightness centers of virtual pixels of another display substrate provided by an embodiment of the present disclosure. As illustrated by Fig. 10, the display substrate 200 includes a pixel arrangement structure 100. The pixel arrangement structure 100 includes at least one array unit 290; the array unit 290 includes a first pixel row 121, a second pixel row 122, a third pixel row 123 and a fourth pixel row 124; the first pixel row 121 includes a plurality of first sub-pixels 111 arranged along the first direction X; the second pixel row 122 includes a plurality of second sub-pixels 112 and a plurality of third sub-pixels 113 that are arranged along the first direction X and are alternately arranged; the third pixel row 123 includes a plurality of first sub-pixels 111 arranged along the first direction X; and the fourth pixel row 124 includes a plurality of second sub-pixels 112 and a plurality of third sub-pixels 113 that are arranged along the first direction X and are alternately arranged. The first pixel row 121, the second pixel row 122, the third pixel row 123 and the fourth pixel row 124 are arranged along the second direction Y that intersects the first direction X, and a virtual isosceles trapezoid is formed by the lines sequentially connecting the centers of two adjacent first sub-pixels 111 in the first pixel row 121 and two adjacent first sub-pixels 111 in the third pixel row 123.

In the pixel arrangement structure provided by the embodiment of the present disclosure, as illustrated by Fig. 11, the lines sequentially connecting the centers of the two adjacent first sub-pixels 111 in the first pixel row 121 and the centers of the two adjacent first sub-pixels 111 in the third pixel row 123 form a virtual isosceles trapezoid, rather than a rectangle or a square. In this way, the pixel arrangement structure can make the distribution of virtual pixels (or white point pixels) more uniform by modulating the positions of sub-pixels of different colors, thus the display problems such as "distortion" and "graininess" caused by the human eye can be solved, and a better display effect can be achieved.

On the other hand, as illustrated by Fig. 11, brightness centers of the virtual pixels in the pixel arrangement structure 100 have three cases, a distribution of the brightness centers of the virtual pixels in odd-numbered rows is the first case, and a distribution of the brightness centers of the virtual pixels in odd-numbered columns of even-numbered rows is the second case, and a distribution of the brightness centers of the virtual pixels in even rows and even columns is the third case. In this way, the pixel arrangement structure can better modulate by using a variety of virtual pixel brightness distributions, so that the white point brightness of the entire screen is more uniform. In addition, in a case that the second sub-pixels and the third sub-pixels borrowed by the first sub-pixels by using a pixel borrowing algorithm are two or more, a variety of virtual pixel brightness distributions can also achieve uniform white point brightness across the entire screen.

For example, the first direction X and the second direction Y may be perpendicular to each other. Of course, the embodiments of the present disclosure include but are not limited thereto, and the first direction X and the second direction Y may not be perpendicular to each other.

For example, the above-mentioned array unit can be the smallest repeating unit of the pixel arrangement structure, and the array unit can cover the entire display substrate by being repeatedly arranged in the first direction and the second direction. Of course, the embodiments of the present disclosure include but are not limited thereto, and the above-mentioned array unit may also be larger than the smallest repeating unit, or smaller than the smallest repeating unit.

In some examples, as illustrated by Fig. 10, the first sub-pixels 111 are configured to emit green light, the second sub-pixels 112 are configured to emit blue light, and the third sub-pixels 113 are configured to emit red light. Of course, the embodiments of the present disclosure include but are not limited thereto, the color of the light emitted by the second sub-pixel and the color of the light emitted by the third sub-pixel can be interchanged, that is, the second sub-pixels are configured to emit red light, and the third sub-pixels are configured to emit blue light.

In some examples, as illustrated by Fig. 10, a shape of each of the second sub-pixels 112 includes a first corner part 112A and a second corner part 112B that are oppositely arranged, a distance between a vertex of the first corner part 112A and a geometric center of a corresponding second sub-pixel 112 is greater than a distance between a vertex of the second corner part 112B and the geometric center of the corresponding second sub-pixel 112; in the second pixel row 122 and the fourth pixel row 124, the arrangement orders of the first corner part 112A and the second corner part 112B of two adjacent second sub-pixels 112 are the same, in other words, the two adjacent second sub-pixels 112 have the same orientation. It should be noted that because the distance between the vertex of the first corner part and the geometric center of the corresponding second sub-pixel is greater than the distance between the vertex of the second corner part and the geometric center of the corresponding second sub-pixel, the second sub-pixel has an orientation in the arrangement direction of the first corner part and the second corner part.

In some examples, as illustrated by Fig. 10, an arrangement direction of the first corner parts 112A and the second corner parts 112B of the second sub-pixels 112 in the second pixel row 122 is perpendicular to an arrangement direction of the first corner parts 112A and the second corner parts 112B of the second sub-pixels 112 in the fourth pixel row 124. In this way, the second sub-pixels in the pixel arrangement structure have two mutually perpendicular orientations.

For example, as illustrated by Fig. 10, two of the second sub-pixels 112 adjacent to each other in the first direction are both oriented to the left, that is, the first corner parts 112A are located on the left side of the corresponding second corner parts 112B respectively; orientations of two of the second sub-pixels 112 adjacent to each other in the second direction are both upward, that is, the first corner part 112A is located above the corresponding second corner part 112B.

In some examples, as illustrated by Fig. 10, a base angle of the virtual isosceles trapezoid formed by the lines sequentially connecting the centers of the two adjacent first sub-pixels 111 in the first pixel row 121 and the centers of the two adjacent first sub-pixels 111 in the third pixel row 123 ranges from 75 degrees to 90 degrees. In this way, the pixel arrangement structure can make the distribution of the brightness centers of the virtual pixels formed by the first sub-pixels, the second sub-pixels and the third sub-pixels more uniform, thus the display problems such as "distortion" and "graininess" caused by the human eye can be better solved.

For example, as illustrated by Fig. 10, the base angle of the virtual isosceles trapezoid formed by the lines sequentially connecting the centers of the two adjacent first sub-pixels 111 in the first pixel row 121 and the centers of the two adjacent first sub-pixels 111 in the third pixel row 123 ranges from 82 degrees to 84 degrees, for example 83 degrees. In this way, the pixel arrangement structure can make the distribution of the brightness centers of the virtual pixels formed by the first sub-pixels, the second sub-pixels and the third sub-pixels more uniform.

In some examples, as illustrated by Fig. 10, the lines sequentially connecting the centers of the two adjacent third sub-pixels 113 in the second pixel row 122 and the centers of the two adjacent third sub-pixels 113 in the fourth pixel row 124 form a virtual square. In this way, the third sub-pixels of the pixel arrangement structure are relatively uniform in the physical spatial arrangement, only the positions of the first sub-pixels and the second sub-pixels need to be modulated, so that the distribution of the brightness centers of the virtual pixels formed by the first sub-pixels, the second sub-pixels and the third sub-pixels is more uniform.

In some examples, as illustrated by Fig. 10, the lines sequentially connecting the centers of the two adjacent second sub-pixels 112 in the second pixel row 122 and the centers of the two adjacent second sub-pixels 112 in the fourth pixel row 124 form a virtual isosceles trapezoid. In this way, the pixel arrangement structure modulates the positions of the first sub-pixels and the second sub-pixels, so that the distribution of the brightness centers of the virtual pixels formed by the first sub-pixels, the second sub-pixels and the third sub-pixels is more uniform.

In some examples, as illustrated by Fig. 10, a base angle of the virtual isosceles trapezoid formed by the lines sequentially connecting the centers of the two adjacent second sub-pixels 112 in the second pixel row 122 and the centers of the two adjacent second sub- pixels 112 in the fourth pixel row 124 ranges from 75 degrees to 90 degrees. In this way, the pixel arrangement structure can make the distribution of the brightness centers of the virtual pixels formed by the first sub-pixels, the second sub-pixels and the third sub-pixels more uniform, thus the display problems such as "distortion" and "graininess" caused by the human eye can be better solved.

In some examples, as illustrated by Fig. 10, in the second pixel row 122 and the fourth pixel row 124, an angle between the line connecting the centers of the second sub-pixel 112 and the third sub-pixel 113 adjacent to each other and the first direction ranges from 1 degree to 15 degrees respectively, and an angle between the line connecting the centers of the second sub-pixel 112 and the third sub-pixel 113 adjacent to each other in the second direction and the second direction ranges from 1 degree to 15 degrees respectively.

In some examples, as illustrated by Fig. 10, in the second pixel row 122 and the fourth pixel row 124, the angle between the line connecting the centers of the second sub-pixel 112 and the third sub-pixel 113 adjacent to each other and the first direction ranges from 6 degrees to 8 degrees respectively.

In some examples, as illustrated by Fig. 10, the angle between the line connecting the centers of the second sub-pixel 112 and the third sub-pixel 113 adjacent to each other in the second direction and the second direction may be 1 degree.

In some examples, as illustrated by Fig. 10, the plurality of second sub-pixels 112 and the plurality of third sub-pixels 113 are alternately arranged along the second direction Y to form a first pixel column 131; the plurality of first sub-pixels 111 are arranged along the second direction Y to form a second pixel column 132. In the second pixel column 132, an angle between a line connecting centers of two adjacent first sub-pixels 111 and the second direction ranges from 1 degree to 15 degrees. In this way, the pixel arrangement structure can make the distribution of the virtual pixels (or white point pixels) in the first direction more uniform, thus the display problems such as "distortion" and "graininess" caused by the human eye can be solved, and a better display effect can be achieved.

In some examples, as illustrated by Fig. 10, in the second pixel column 132, the angle between the line connecting the centers of the two adjacent first sub-pixels 111 and the second direction ranges from 6 degrees to 8 degrees, for example, 7 degrees. In this way, the pixel arrangement structure can further make the distribution of the virtual pixels (or white point pixels) in the first direction more uniform, thus the display problems such as "distortion" and "graininess" caused by the human eye can be solved, and a better display effect can be achieved.

In some examples, as illustrated by Fig. 10, each of the first sub-pixels 111 is located within the range of the virtual quadrilateral formed by the lines sequentially connecting the centers of the two adjacent second sub-pixels 112 and the two adjacent third sub-pixels 113. That is, each of the first sub-pixels 111 is surrounded by the two second sub-pixels 112 and the two third sub-pixels 113 that are adjacent to each other. In this way, the pixel arrangement structure can better realize pixel borrowing, and achieve higher display quality.

In some examples, as illustrated by Fig. 10, a first distance L1 and a second distance L2 are provided between the first sub-pixel 111 and the two second sub-pixels 112 for forming the virtual quadrilateral respectively, a third distance L3 and a fourth distance L4 are provided between the first sub-pixel 111 and the two third sub-pixels 113 for forming the virtual quadrilateral respectively; and at least two of the first distance L1, the second distance L2, the third distance L3 and the fourth distance L4 are equal. In this way, the pixel arrangement structure can make full use of process accuracy, and improve the aperture ratio of each of the sub-pixels.

In some examples, as illustrated by Fig. 10, the first distance L1, the second distance L2, the third distance L3, and the fourth distance L4 are all equal, that is, L1=L2=L3=L4.

In some examples, as illustrated by Fig. 10, the first distance L1 and the second distance L2 are equal, and the third distance L3 and the fourth distance L4 are not equal, that is, L1=L2, L3≠L4.

Of course, the embodiments of the present disclosure include but are not limited thereto, and the first distance L1, the second distance L2, the third distance L3, and the fourth distance L4 mentioned above may also be unequal.

In some examples, a geometric center of the first sub-pixel 111 is not located at a geometric center of the virtual quadrilateral formed by the lines sequentially connecting the centers of the two adjacent second sub-pixels 112 and the two adjacent third sub-pixels 113.

Fig. 12 is a planar schematic diagram of still another display substrate provided by an embodiment of the present disclosure. As illustrated by Fig. 12, the display substrate 200 includes a pixel arrangement structure 100. Different from the display substrate shown in Fig. 10, the two second sub-pixels 112 adjacent in the first direction are all oriented to the left. that is, the first corner part 112A is located on the left side of the corresponding second corner part 112B; the orientations of the two adjacent second sub-pixels 112 in the second direction are both downward, that is, the first corner part 112A is located above the corresponding second corner part 112B. That is, in a case that an arrangement direction of the first corner parts 112A and the second corner parts 112B of the second sub-pixels 112 in the second pixel row 122 is perpendicular to an arrangement direction of the first corner parts 112A and the second corner parts 112B of the second sub-pixels 112 in the fourth pixel row 124, the second sub-pixels 112 in the second pixel row 122 may be oriented toward the left or right, and the second sub-pixels 112 in the fourth pixel row 124 may be oriented upward or downward.

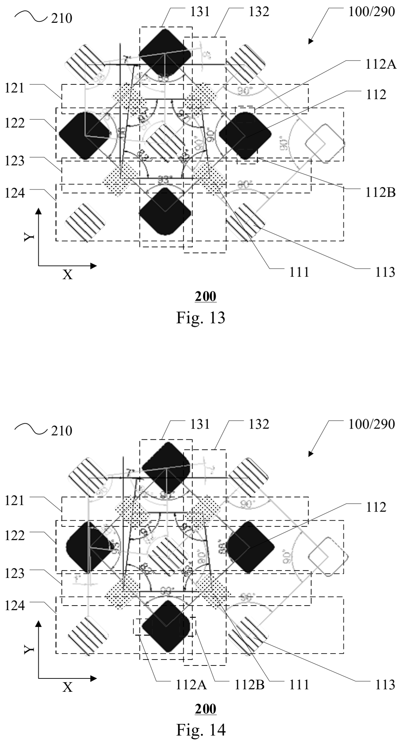

Fig. 13 is a planar schematic diagram of still another display substrate provided by an embodiment of the present disclosure. As illustrated by Fig. 13, the display substrate 200 includes a base substrate 210 and a pixel arrangement structure 100 located on the base substrate 210. The pixel arrangement structure 100 includes at least one array unit 290; the array unit 290 includes a first pixel row 121, a second pixel row 122, a third pixel row 123 and a fourth pixel row 124; the first pixel row 121 includes a plurality of first sub-pixels 111 arranged along the first direction X; the second pixel row 122 includes a plurality of second sub-pixels 112 and a plurality of third sub-pixels 113 that are arranged along the first direction X and are alternately arranged; the third pixel row 123 includes a plurality of first sub-pixels 111 arranged along the first direction X; the fourth pixel row 124 includes a plurality of second sub-pixels 112 and a plurality of third sub-pixels 113 that are arranged along the first direction X and are alternately arranged. The first pixel row 121, the second pixel row 122, the third pixel row 123 and the fourth pixel row 124 are arranged along the second direction Y that intersects the first direction X, and a virtual isosceles trapezoid is formed by lines sequentially connecting the centers of the two adjacent first sub-pixels 111 in the first pixel row 121 and the centers of the two adjacent first sub-pixels 111 in the third pixel row 123.

In the pixel arrangement structure provided by the embodiment of the present disclosure, the lines sequentially connecting the centers of the two adjacent first sub-pixels in the first pixel row and the centers of the two adjacent first sub-pixels in the third pixel row form a virtual isosceles trapezoid, rather than a rectangle or a square. In this way, the pixel arrangement structure can make the distribution of virtual pixels (or white point pixels) more uniform by modulating the positions of the sub-pixels of different colors, thus the display problems such as "distortion" and "graininess" caused by the human eye can be solved, and a better display effect can be achieved.

For example, the first direction X and the second direction Y may be perpendicular to each other. Of course, the embodiments of the present disclosure include but are not limited thereto, and the first direction X and the second direction Y may not be perpendicular to each other.

For example, the above-mentioned array unit can be the smallest repeating unit of the pixel arrangement structure, and the array unit can cover the entire display substrate by being repeatedly arranged in the first direction and the second direction. Of course, the embodiments of the present disclosure include but are not limited thereto, and the above-mentioned array unit may also be larger than the smallest repeating unit, or smaller than the smallest repeating unit.

In some examples, as illustrated by Fig. 13, the first sub-pixels 111 are configured to emit green light, the second sub-pixels 112 are configured to emit blue light, and the third sub-pixels 113 are configured to emit red light. Of course, embodiments of the present disclosure include but are not limited thereto, the color of the light emitted by the second sub-pixels and the color of the light emitted by the third sub-pixels can be interchanged, that is, the second sub-pixels are configured to emit red light, and the third sub-pixels are configured to emit blue light.

In some examples, as illustrated by Fig. 13, a shape of each of the second sub-pixels 112 includes a first corner part 112A and a second corner part 112B that are arranged oppositely, a distance between a vertex of the first corner part 112A and a geometric center of a corresponding second sub-pixel 112 is greater than a distance between a vertex of the second corner 112B and the geometric center of the corresponding second sub-pixel 112; in the second pixel row 122 and the fourth pixel row 124, the arrangement order of the first corner part 112A and the second corner part 112B of the two adjacent second sub-pixels 112 are the same; an arrangement direction of the first corner part 112A and the second corner part 112B of the second sub-pixels 112 in the second pixel row 122 is opposite to an arrangement direction of the first corner part 112A and the second corner part 112B of the second sub-pixels 112 in the fourth pixel row 124.

In some examples, as illustrated by Fig. 13, the first corner parts 112A of the second sub-pixels 112 in the second pixel row 122 are located below the corresponding second corner parts 112B, and the first corner parts 112A of the second sub-pixels 112 in the fourth pixel row 124 are located above the corresponding second corner parts 112B.

In some examples, as illustrated by Fig. 13, in the second pixel row 122 and the fourth pixel row 124, an angle between the line connecting the centers of the second sub-pixel 112 and the third sub-pixel 113 adjacent to each other and the first direction ranges from 1 degree to 15 degrees respectively, and an angle between the line connecting the centers of the second sub-pixel 112 and the third sub-pixel 113 adjacent to each other in the second direction and the second direction ranges from 1 degree to 15 degrees respectively.

In some examples, as illustrated by Fig. 13, in the second pixel row 122 and the fourth pixel row 124, the angle between the line connecting the centers of the second sub-pixel 112 and the third sub-pixel 113 adjacent to each other and the first direction ranges from 7 degrees to 8 degrees respectively, for example 8 degrees.

Fig. 14 is a planar schematic diagram of still another display substrate provided by an embodiment of the present disclosure. As illustrated by Fig. 14, the display substrate 200 includes a base substrate 210 and a pixel arrangement structure 100 located on the base substrate 210. Different from the display substrate shown in Fig. 13, in the pixel arrangement structure shown in Fig. 14, the first corner parts 112A of the second sub-pixels 112 in the second pixel row 122 are located at right side of the corresponding second corner parts 112B, and the first corner parts 112A of the second sub-pixels 112 in the fourth pixel row 124 are located at left side of the corresponding second corner parts 112B.

In some examples, as illustrated by Fig. 14, in the second pixel row 122 and the fourth pixel row 124, the angle between the line connecting the centers of the second sub-pixel 112 and the third sub-pixel 113 adjacent to each other and the first direction ranges from 7 degrees to 8 degrees respectively, for example, 7 degrees.

In some examples, as illustrated by Fig. 14, an angle between the line connecting the centers of the second sub-pixel 112 and the third sub-pixel 113 adjacent to each other in the second direction and the second direction ranges from 1 degree to 3 degrees respectively, for example, 1 degree.

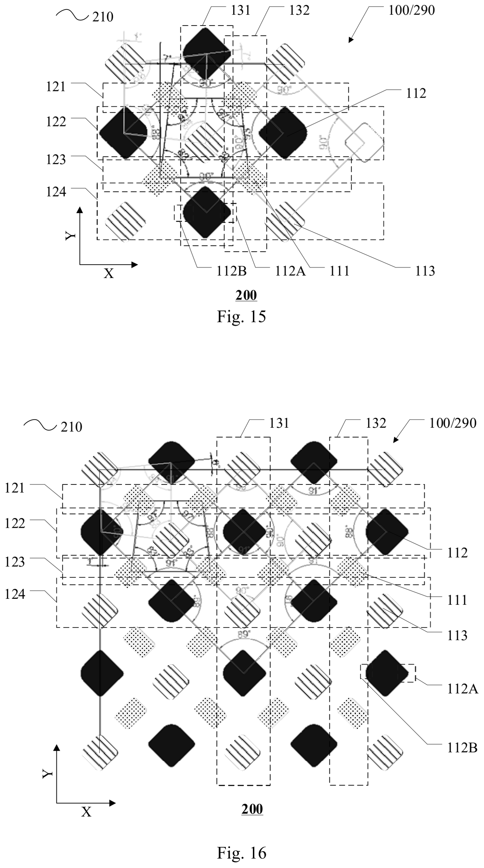

Fig. 15 is a planar schematic diagram of still another display substrate provided by an embodiment of the present disclosure. As illustrated by Fig. 15, the display substrate 200 includes a base substrate 210 and a pixel arrangement structure 100 located on the base substrate 210. Different from the display substrate shown in Fig. 13, in the pixel arrangement structure shown in Fig. 15, the first corner parts 112A of the second sub-pixels 112 in the second pixel row 122 are located at left side of the corresponding second corner parts 112B, and the first corner parts 112A of the second sub-pixels 112 in the fourth pixel row 124 are located at right side of the corresponding second corner parts 112B.

Fig. 16 is a planar schematic diagram of still another display substrate provided by an embodiment of the present disclosure. As illustrated by Fig. 16, the display substrate 200 includes a base substrate 210 and a pixel arrangement structure 100 located on the base substrate 210. The pixel arrangement structure 100 includes at least one array unit 290; the array unit 290 includes a first pixel row 121, a second pixel row 122, a third pixel row 123 and a fourth pixel row 124; the first pixel row 121 includes a plurality of first sub-pixels 111 arranged along the first direction X; the second pixel row 122 includes a plurality of second sub-pixels 112 and a plurality of third sub-pixels 113 that are arranged along the first direction X and are alternately arranged; the third pixel row 123 includes a plurality of first sub-pixels 111 arranged along the first direction X; the fourth pixel row 124 includes a plurality of second sub-pixels 112 and a plurality of third sub-pixels 113 that are arranged along the first direction X and are alternately arranged. The first pixel row 121, the second pixel row 122, the third pixel row 123 and the fourth pixel row 124 are arranged along the second direction Y that intersects the first direction X, and a virtual isosceles trapezoid is formed by lines sequentially connecting centers of two adjacent first sub-pixels 111 in the first pixel row 121 and centers of two adjacent first sub-pixels 111 in the third pixel row 123.

In the pixel arrangement structure provided by the embodiment of the present disclosure, the lines sequentially connecting centers of the two adjacent first sub-pixels in the first pixel row and centers of the two adjacent first sub-pixels in the third pixel row form a virtual isosceles trapezoid, rather than a rectangle or a square. In this way, the pixel arrangement structure can make the distribution of virtual pixels (or white point pixels) more uniform by modulating the positions of sub-pixels of different colors, thus the display problems such as "distortion" and "graininess" caused by the human eye can be solved, and a better display effect can be achieved.

For example, the first direction X and the second direction Y may be perpendicular to each other. Of course, the embodiments of the present disclosure include but are not limited thereto, and the first direction X and the second direction Y may not be perpendicular to each other.

For example, the above-mentioned array unit can be the smallest repeating unit of the pixel arrangement structure, and the array unit can cover the entire display substrate by being repeatedly arranged in the first direction and the second direction. Of course, the embodiments of the present disclosure include but are not limited thereto, and the above-mentioned array unit may also be larger than the smallest repeating unit, or smaller than the smallest repeating unit.

In some examples, as illustrated by Fig. 16, the first sub-pixels 111 are configured to emit green light, the second sub-pixels 112 are configured to emit blue light, and the third sub-pixels 113 are configured to emit red light. Of course, the embodiments of the present disclosure include but are not limited thereto, the color of the light emitted by the second sub-pixels and the color of the light emitted by the third sub-pixels can be interchanged, that is, the second sub-pixels are configured to emit red light, and the third sub-pixels are configured to emit blue light.

In some examples, as illustrated by Fig. 16, a shape of each of the second sub-pixels 112 includes a first corner part 112A and a second corner part 112B arranged oppositely, a distance between a vertex of the first corner 112A and a geometric center of a corresponding second sub-pixel 112 is greater than a distance between the second corner part 112B and the geometric center of the corresponding second sub-pixel 112; in the second pixel row 122 and the fourth pixel row 124, the arrangement orders of the first corner part 112A and the second corner part 112B of the two adjacent second sub-pixels 112 are the same; an arrangement direction of the first corner part 112A and the second corner part 112B of the second sub-pixels 112 in the second pixel row 122 is perpendicular to an arrangement direction of the first corner part 112A and the second corner part 112B of the second sub-pixels 112 in the fourth pixel row 124, the arrangement orders of the first corner part 112A and the second corner part 112B of the two adjacent second sub-pixels 112 in the second direction are different, for example, the arrangement orders are opposite. That is, the second sub-pixels 112 have three orientations, two of which are parallel, and the other one is perpendicular to the two orientations.

In some examples, as illustrated by Fig. 16, the lines sequentially connecting the centers of the two third sub-pixels 113 of the second pixel row 122 and the centers of the two third sub-pixels 113 of the fourth pixel row 124 may form a virtual square. The lines sequentially connecting the centers of the two second sub-pixels 112 of the second pixel row 122 and the centers of the two second sub-pixels 112 of the fourth pixel row 124 may form a virtual isosceles trapezoid.

In some examples, as illustrated by Fig. 16, a base angle of the virtual isosceles trapezoid formed by the lines sequentially connecting the centers of the two adjacent second sub-pixels 112 in the second pixel row 122 and the centers of the two adjacent second sub- pixels 112 in the fourth pixel row 124 ranges from 75 degrees to 90 degrees. In this way, the pixel arrangement structure can make the distribution of the brightness centers of the virtual pixels formed by the first sub-pixels, the second sub-pixels and the third sub-pixels more uniform, thus the display problems such as "distortion" and "graininess" caused by the human eye can be better solved.

In some examples, as illustrated by Fig. 16, the base angle of the virtual isosceles trapezoid formed by the lines sequentially connecting the centers of the two adjacent first sub-pixels 111 in the first pixel row 121 and the centers of the two adjacent first sub-pixels 111 in the third pixel row 123 ranges from 75 degrees to 90 degrees. In this way, the pixel arrangement structure can make the distribution of the brightness centers of the virtual pixels formed by the first sub-pixels, the second sub-pixels and the third sub-pixels more uniform, thus the display problems such as "distortion" and "graininess" caused by the human eye can be better solved.

In some examples, as illustrated by Fig. 16, in the second pixel row 122 and the fourth pixel row 124, an angle between the line connecting the centers of the second sub-pixel 112 and the third sub-pixel 113 adjacent to each other and the first direction ranges from 1 degree to 15 degrees respectively, and an angle between the line connecting the centers of the second sub-pixel 112 and the third sub-pixel 113 adjacent to each other in the second direction and the second direction ranges from 1 degree to 15 degrees respectively.

In some examples, as illustrated by Fig. 16, in the second pixel row 122 and the fourth pixel row 124, the angle between the line connecting the centers of the second sub-pixel 112 and the third sub-pixel 113 adjacent to each other and the first direction ranges from 1 degree to 3 degrees respectively; and in the second pixel row 122 and the fourth pixel row 124, the angle between the line connecting the centers of the second sub-pixel 112 and the third sub-pixel 113 adjacent to each other and the first direction ranges from 5 degrees to 7 degrees.

In some examples, as illustrated by Fig. 16, in the pixel column in which the first corner parts 112A of the second sub-pixels 112 are located above the corresponding second corner parts 112, an angle between the line connecting the centers of the second sub-pixel 112 and the third sub-pixel 113 adjacent to each other in the second direction and the second direction may be 1 degree.

In some examples, as illustrated by Fig. 16, each of the first sub-pixels 111 is located within a range of the virtual quadrilateral formed by the lines sequentially connecting the centers of the two adjacent second sub-pixels 112 and the centers of the two adjacent third sub-pixels 113. That is, each of the first sub-pixels 111 is surrounded by the two adjacent second sub-pixels 112 and the two adjacent third sub-pixels 113. In this way, the pixel arrangement structure can better realize pixel borrowing, and achieve higher display quality.

In some examples, as illustrated by Fig. 16, a first distance L1 and a second distance L2 are provided between the first sub-pixel 111 and the two second sub-pixels 112 for forming the virtual quadrilateral respectively, a third distance L3 and a fourth distance L4 are provided between the first sub-pixel 111 and the two third sub-pixels 113 for forming the virtual quadrilateral respectively; and at least two of the first distance L1, the second distance L2, the third distance L3 and the fourth distance L4 are equal. In this way, the pixel arrangement structure can make full use of process accuracy, and improve the aperture ratio of each of the sub-pixels.

In some examples, as illustrated by Fig. 16, the first distance L1, the second distance L2, the third distance L3 and the fourth distance L4 are all equal, that is, L1=L2=L3=L4.

In some examples, as illustrated by Fig. 16, the first distance L1 and the second distance L2 are equal, and the third distance L3 and the fourth distance L4 are not equal, that is, L1=L2, L3#L4.

Of course, the embodiments of the present disclosure include but are not limited thereto, and the first distance L1, the second distance L2, the third distance L3, and the fourth distance L4 mentioned above may also be unequal.

In some examples, a geometric center of the first sub-pixel 111 is not located at a geometric center of the virtual quadrilateral formed by the lines sequentially connecting the centers of the two adjacent second sub-pixels 112 and the centers of the two adjacent third sub-pixels 113.

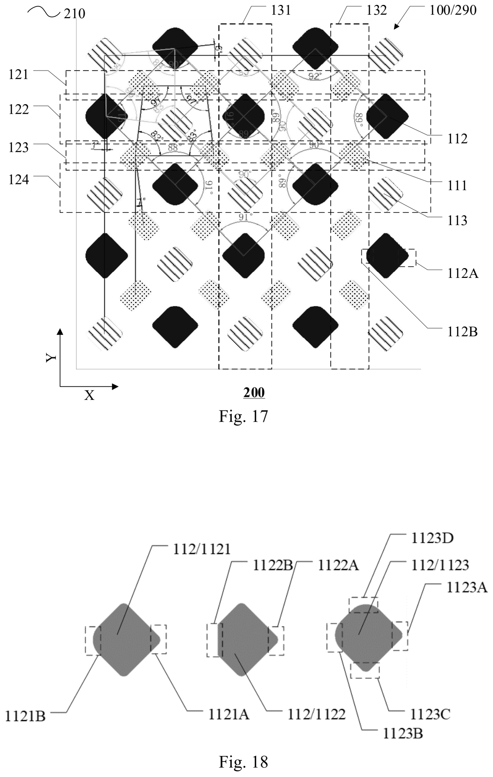

Fig. 17 is a planar schematic diagram of still another display substrate provided by an embodiment of the present disclosure. As illustrated by Fig. 17, the display substrate 200 includes a base substrate 210 and a pixel arrangement structure 100 located on the base substrate 210. Different from the display substrate shown in Fig. 16, in the pixel arrangement structure shown in Fig. 17, in the second pixel row 122 and the fourth pixel row 124, arrangement orders of the first corner part 112A and the second corner part 112B of two adjacent second sub-pixels 112 are different, for example, the arrangement orders are opposite; an arrangement direction of the first corner part 112A and the second corner part 112B of the second sub-pixels 112 in the second pixel row 122 is perpendicular to an arrangement direction of the first corner part 112A and the second corner part 112B of the second sub-pixels 112 in the fourth pixel row 124, and arrangement orders of the first corner part 112A and the second corner part 112B of the two second sub-pixels 112 adjacent in the second direction are the same.

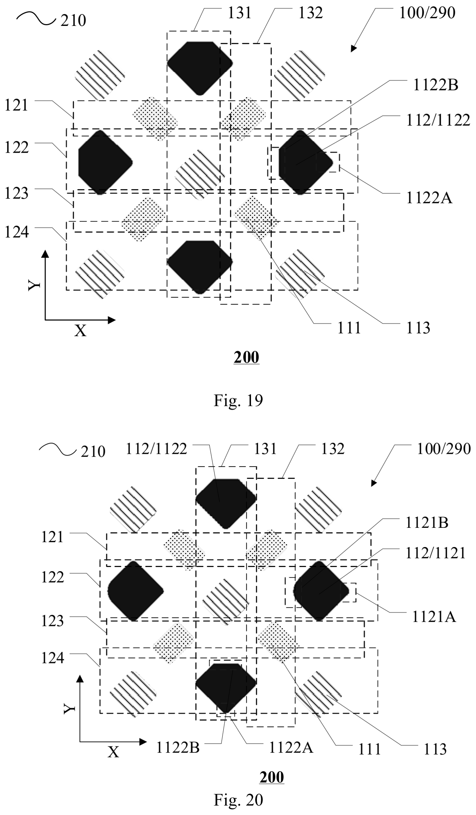

Fig. 18 is a schematic diagram of three shapes of a second sub-pixel provided by an embodiment of the present disclosure; Fig. 19 is a planar schematic diagram of still another display substrate provided by an embodiment of the present disclosure; and Fig. 20 is a s planar schematic diagram of still another display substrate provided by an embodiment of the present disclosure. As illustrated by Fig. 19 to Fig. 20, the display substrate 200 includes a base substrate 210 and a pixel arrangement structure 100 located on the base substrate 210. The pixel arrangement structure 100 includes at least one array unit 290; the array unit 290 includes a first pixel row 121, a second pixel row 122, a third pixel row 123 and a fourth pixel row 124; the first pixel row 121 includes a plurality of first sub-pixels 111 arranged along the first direction X; the second pixel row 122 includes a plurality of second sub-pixels 112 and a plurality of third sub-pixels 113 that are arranged along the first direction X and are alternately arranged; the third pixel row 123 includes a plurality of first sub-pixels 111 arranged along the first direction X; the fourth pixel row 124 includes a plurality of second sub-pixels 112 and a plurality of third sub-pixels 113 that are arranged along the first direction X and are alternately arranged. The first pixel row 121, the second pixel row 122, the third pixel row 123 and the fourth pixel row 124 are arranged along the second direction Y that intersects the first direction X, and a virtual isosceles trapezoid is formed by lines sequentially connecting centers of two adjacent first sub-pixels 111 in the first pixel row 121 and centers of two adjacent first sub-pixels 111 in the third pixel row 123.

In the pixel arrangement structure provided by the embodiment of the present disclosure, the lines sequentially connecting the centers of the two adjacent first sub-pixels in the first pixel row and the centers of the two adjacent first sub-pixels in the third pixel row form a virtual isosceles trapezoid, rather than a rectangle or a square. In this way, the pixel arrangement structure can make the distribution of virtual pixels (or white point pixels) more uniform by modulating the positions of sub-pixels of different colors, thus the display problems such as "distortion" and "graininess" caused by the human eye can be solved, and a better display effect can be achieved.

For example, the first direction X and the second direction Y may be perpendicular to each other. Of course, the embodiments of the present disclosure include but are not limited thereto, and the first direction X and the second direction Y may not be perpendicular to each other.

For example, the above-mentioned array unit can be the smallest repeating unit of the pixel arrangement structure, and the array unit can cover the entire display substrate by being repeatedly arranged in the first direction and the second direction. Of course, the embodiments of the present disclosure include but are not limited thereto, the above-mentioned array unit may also be larger than the smallest repeating unit, or smaller than the smallest repeating unit.

In some examples, as illustrated by Fig. 19 to Fig. 20, the first sub-pixels 111 are configured to emit green light, the second sub-pixels 112 are configured to emit blue light, and the third sub-pixels 113 are configured to emit red light. Of course, the embodiments of the present disclosure include but are not limited thereto, the color of the light emitted by the second sub-pixels and the color of the light emitted by the third sub-pixels can be interchanged, that is, the second sub-pixels are configured to emit red light, and the third sub-pixels are configured to emit blue light.

In some examples, as illustrated by Fig. 18, a shape of each of the second sub-pixels 112 includes at least one of a first shape 1121, a second shape 1122 and a third shape 1123; the first shape 1121 includes a first corner part 1121A and a second corner part 1121B arranged oppositely, a distance between a vertex of the first corner part 1121A and a geometric center of a corresponding second sub-pixel 112 is greater than a distance between a vertex of the second corner 1121B and the geometric center of the corresponding second sub-pixel 112; the second shape 1122 includes a third corner part 1122A and a flattened part 1122B arranged oppositely, an edge of the flattened part 1122B away from the third corner part 1122A is a straight line; the third shape 1123 includes a fourth corner part 1123A and a fifth corner part 1134B that are oppositely arranged in the first direction, and a sixth corner part 1123C and a seventh corner part 1123D arranged oppositely in the second direction, a distance between a vertex of the fourth corner part 1123A and the geometric center of a corresponding second sub-pixel 112 is greater than a distance between a vertex of the fifth corner part 1123B and the geometric center of the corresponding second sub-pixel 112, a distance between a vertex of the sixth corner part 1123C and the geometric center of the corresponding second sub-pixel 112 is greater than the distance between a seventh corner part 1123D and the geometric center of the corresponding second sub-pixel 112, and the fifth corner part 1123B and the seventh corner part 1123D are arranged adjacent to each other.

In some examples, as illustrated by Fig. 19, in the pixel arrangement structure 100, the shape of the second sub-pixel 112 is a second shape. In the second pixel row 122 and the fourth pixel row 124, two adjacent second sub-pixels 112 have a same orientation, and two second sub-pixels 112 adjacent to each other in the second direction have a same orientation.

In some examples, as illustrated by Fig. 20, in the pixel arrangement structure, the shapes of the second sub-pixels 112 include the second shape and the first shape.

In some examples, as illustrated by Fig. 20, the shape of the second sub-pixels 112 in the second pixel row 122 and the shape of the second sub-pixels 112 in the fourth pixel row 124 are different. For example, the shape of the second sub-pixels 112 in the second pixel row 122 is the first shape, the shape of the second sub-pixels 112 in the fourth pixel row 124 is the second shape.

It should be noted that, in a case that the embodiment of the present disclosure discloses that the shape of the second sub-pixel 112 includes at least one of the first shape, the second shape and the third shape mentioned above, and the pixel arrangement structure can adopt any one or a combination of at least two of the three second sub-pixels with the above three shapes, which will not be described in detail herein.

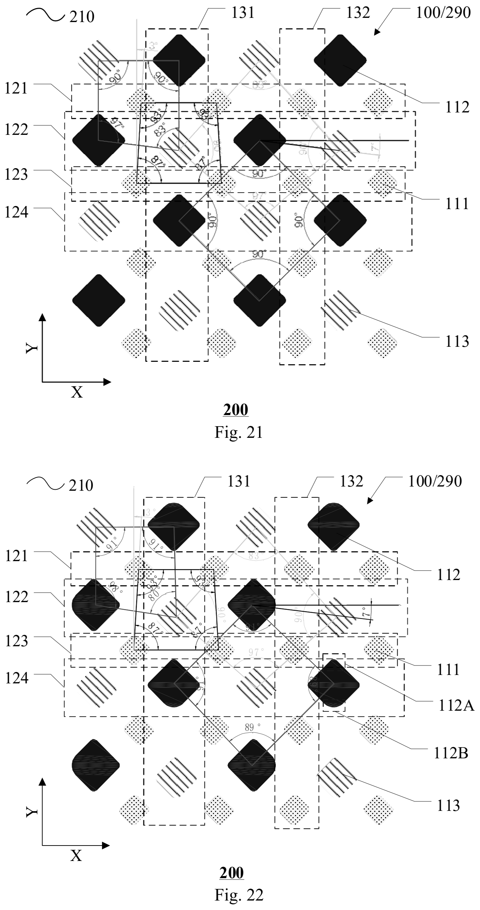

Fig. 21 is a planar schematic diagram of still another display substrate provided by an embodiment of the present disclosure. As illustrated by Fig. 21, the display substrate 200 includes a base substrate 210 and a pixel arrangement structure 100 located on the base substrate 210. The pixel arrangement structure 100 includes at least one array unit 290; the array unit 290 includes a first pixel row 121, a second pixel row 122, a third pixel row 123 and a fourth pixel row 124; the first pixel row 121 includes a plurality of first sub-pixels 111 arranged along the first direction X; the second pixel row 122 includes a plurality of second sub-pixels 112 and a plurality of third sub-pixels 113 that are arranged along the first direction X and are alternately arranged; the third pixel row 123 includes a plurality of first sub-pixels 111 arranged along the first direction X; and the fourth pixel row 124 includes a plurality of second sub-pixels 112 and a plurality of third sub-pixels 113 that are arranged along the first direction X and are alternately arranged. The first pixel row 121, the second pixel row 122, the third pixel row 123 and the fourth pixel row 124 are arranged along the second direction Y that intersects the first direction X, and a virtual isosceles trapezoid is formed by lines sequentially connecting centers of two adjacent first sub-pixels 111 in the first pixel row 121 and centers of two adjacent first sub-pixels 111 in the third pixel row 123.

In the pixel arrangement structure provided by the embodiment of the present disclosure, the lines sequentially connecting the centers of the two adjacent first sub-pixels in the first pixel row and the centers of the two adjacent first sub-pixels in the third pixel row form a virtual isosceles trapezoid, rather than a rectangle or a square. In this way, the pixel arrangement structure can make the distribution of virtual pixels (or white point pixels) more uniform by modulating the positions of sub-pixels of different colors, thus the display problems such as "distortion" and "graininess" caused by the human eye can be solved, and a better display effect can be achieved.

For example, the first direction X and the second direction Y may be perpendicular to each other. Of course, the embodiments of the present disclosure include but are not limited thereto, and the first direction X and the second direction Y may not be perpendicular to each other.

For example, the above-mentioned array unit can be the smallest repeating unit of the pixel arrangement structure, and the array unit can cover the entire display substrate by being repeatedly arranged in the first direction and the second direction. Of course, the embodiments of the present disclosure include but are not limited thereto, and the above-mentioned array unit may also be larger than the smallest repeating unit, or smaller than the smallest repeating unit.

In some examples, as illustrated by Fig. 21, the first sub-pixels 111 are configured to emit green light, the second sub-pixels 112 are configured to emit blue light, and the third sub-pixels 113 are configured to emit red light.

In some examples, as illustrated by Fig. 21, a base angle of the virtual isosceles trapezoid formed by the lines sequentially connecting the centers of the two adjacent first sub-pixels 111 in the first pixel row 121 and the centers of the two adjacent first sub-pixels 111 in the third pixel row 123 ranges from 75 degrees to 90 degrees. In this way, the pixel arrangement structure can make the distribution of the brightness centers of the virtual pixels formed by the first sub-pixels, the second sub-pixels and the third sub-pixels more uniform, thus the display problems such as "distortion" and "graininess" caused by the human eye can be better solved.

For example, as illustrated by Fig. 21, the base angle of the virtual isosceles trapezoid formed by the lines sequentially connecting the centers of the two adjacent first sub-pixels 111 in the first pixel row 121 and the centers of the two adjacent first sub-pixels 111 in the third pixel row 123 ranges from 86 degrees to 88 degrees, for example, 87 degrees. In this way, the pixel arrangement structure can make the distribution of the brightness centers of the virtual pixels formed by the first sub-pixels, the second sub-pixels and the third sub-pixels more uniform.

In some examples, as illustrated by Fig. 21, lines sequentially connecting the centers of two adjacent second sub-pixels 112 in the second pixel row 122 and two adjacent second sub-pixels 112 in the fourth pixel row 124 form a virtual square.

In some examples, as illustrated by Fig. 21, lines sequentially connecting the centers of two adjacent third sub-pixels 113 in the second pixel row 122 and two adjacent third sub-pixels 113 in the fourth pixel row 124 form a virtual quadrilateral.

For example, as illustrated by Fig. 21, four interior angles of the virtual quadrilateral formed by the lines sequentially connecting the centers of the two adjacent third sub-pixels 113 in the second pixel row 122 and the centers of the two adjacent third sub-pixels 113 in the fourth pixel row 124 are 83 degrees, 90 degrees, 97 degrees and 90 degrees respectively.

In some examples, as illustrated by Fig. 21, the shapes of the first sub-pixels 111, the second sub-pixels 112 and the third sub-pixels 113 are all rectangles or rounded rectangles. It should be noted that, the above-mentioned rounded rectangles refer to a figure in which four corners of a rectangle have been rounded.

In some examples, as illustrated by Fig. 21, each of the first sub-pixels 111 is located within a range of the virtual quadrilateral formed by the lines sequentially connecting the centers of the two adjacent second sub-pixels 112 and the centers of the two adjacent third sub-pixels 113. That is, each of the first sub-pixels 111 is surrounded by the two adjacent second sub-pixels 112 and the two third sub-pixels 113. In this way, the pixel arrangement structure can better realize pixel borrowing, and achieve higher display quality.

In some examples, as illustrated by Fig. 21, a first distance L1 and a second distance L2 are provided between the first sub-pixel 111 and the two second sub-pixels 112 for forming the virtual quadrilateral respectively, a third distance L3 and a fourth distance L4 are provided between the first sub-pixel 111 and the two third sub-pixels 113 for forming the virtual quadrilateral respectively; and at least two of the first distance L1, the second distance L2, the third distance L3 and the fourth distance L4 are equal. In this way, the pixel arrangement structure can make full use of process accuracy, and improve the aperture ratio of each of the sub-pixels.

In some examples, as illustrated by Fig. 21, the first distance L1, the second distance L2, the third distance L3 and the fourth distance L4 are all equal, that is, L1=L2=L3=L4.

In some examples, as illustrated by Fig. 21, the first distance L1 and the second distance L2 are equal, and the third distance L3 and the fourth distance L4 are not equal, that is, L1=L2, L3#L4.

Of course, the embodiments of the present disclosure include but are not limited thereto, and the first distance L1, the second distance L2, the third distance L3, and the fourth distance L4 mentioned above may also be unequal.

In some examples, a geometric center of the first sub-pixel 111 is not located at a geometric center of the virtual quadrilateral formed by the lines sequentially connecting the centers of the two adjacent second sub-pixels 112 and the centers of the two adjacent third sub-pixels 113.

In some examples, as illustrated by Fig. 21, the plurality of second sub-pixels 112 and the plurality of third sub-pixels 113 are alternately arranged along the second direction to form a first pixel column; the plurality of first sub-pixels 111 are arranged along the second direction Y to form a second pixel column 132. In the second pixel column 132, an angle between the line connecting the centers of the two adjacent first sub-pixels 111 and the second direction ranges from 1 degree to 15 degrees. In this way, the pixel arrangement structure can make the distribution of virtual pixels (or white point pixels) in the first direction more uniform, thus the display problems such as "distortion" and "graininess" caused by the human eye can be solved, and a better display effect can be achieved.

In some examples, as illustrated by Fig. 21, the angle between the line connecting the centers of the two adjacent first sub-pixels 111 and the second direction ranges from 2 degrees to 4 degrees, for example, 3 degrees. In this way, the pixel arrangement structure can further make the distribution of virtual pixels (or white point pixels) in the first direction more uniform, thus the display problems such as "distortion" and "graininess" caused by the human eye can be solved, and a better display effect can be achieved.

In some examples, as illustrated by Fig. 21, in the first pixel row 121 and the third pixel row 123, the line connecting the centers of the two adjacent first sub-pixels 111 is parallel to the first direction.

In some examples, as illustrated by Fig. 21, in the second pixel row 122 and the fourth pixel row 124, an angle between the line connecting the centers of the second sub-pixel 112 and the third sub-pixel 113 adjacent to each other and the first direction ranges from 1 degree to 15 degrees respectively. In this way, the pixel arrangement structure can make the distribution of virtual pixels (or white point pixels) more uniform, thus the display problems such as "distortion" and "graininess" caused by the human eye can be solved, and a better display effect can be achieved.

In some examples, as illustrated by Fig. 21, in the second pixel row 122 and the fourth pixel row 124, the angle between the line connecting the centers of the second sub-pixel 112 and the third sub-pixel 113 adjacent to each other and the first direction ranges from 6 degrees to 8 degrees respectively, for example, 7 degrees. In this way, the pixel arrangement structure can make the distribution of virtual pixels (or white point pixels) more uniform, thus the display problems such as "distortion" and "graininess" caused by the human eye can be solved, and a better display effect can be achieved.

Fig. 22 is a planar schematic diagram of still another display substrate provided by an embodiment of the present disclosure. As illustrated by Fig. 22, the display substrate 200 includes a base substrate 210 and a pixel arrangement structure 100 located on the base substrate 210. The pixel arrangement structure 100 includes at least one array unit 290; the array unit 290 includes a first pixel row 121, a second pixel row 122, a third pixel row 123 and a fourth pixel row 124; the first pixel row 121 includes a plurality of first sub-pixels 111 arranged along the first direction X; the second pixel row 122 includes a plurality of second sub-pixels 112 and a plurality of third sub-pixels 113 that are arranged along the first direction X and are alternately arranged; the third pixel row 123 includes a plurality of first sub-pixels 111 arranged along the first direction X; the fourth pixel row 124 includes a plurality of second sub-pixels 112 and a plurality of third sub-pixels 113 that are arranged along the first direction X and are alternately arranged. The first pixel row 121, the second pixel row 122, the third pixel row 123 and the fourth pixel row 124 are arranged along the second direction Y that intersects the first direction X, a virtual isosceles trapezoid is formed by lines sequentially connecting centers of two adjacent first sub-pixels 111 in the first pixel row 121 and centers of two adjacent first sub-pixels 111 in the third pixel row 123.

In the pixel arrangement structure provided by the embodiment of the present disclosure, lines sequentially connecting the centers of two adjacent first sub-pixels in the first pixel row and two adjacent first sub-pixels in the third pixel row form a virtual isosceles trapezoid, rather than a rectangle or a square. In this way, the pixel arrangement structure can make the distribution of virtual pixels (or white point pixels) more uniform by modulating the positions of sub-pixels of different colors, thus the display problems such as "distortion" and "graininess" caused by the human eye can be solved, and a better display effect can be achieved.

For example, the first direction X and the second direction Y may be perpendicular to each other. Of course, the embodiments of the present disclosure include but are not limited thereto, and the first direction X and the second direction Y may not be perpendicular to each other.

For example, the above-mentioned array unit can be the smallest repeating unit of the pixel arrangement structure, and the array unit can cover the entire display substrate by being repeatedly arranged in the first direction and the second direction. Of course, the embodiments of the present disclosure include but are not limited thereto, and the above-mentioned array unit may also be larger than the smallest repeating unit, or smaller than the smallest repeating unit.

In some examples, as illustrated by Fig. 22, the first sub-pixels 111 are configured to emit green light, the second sub-pixels 112 are configured to emit blue light, and the third sub-pixels 113 are configured to emit red light.

In some examples, as illustrated by Fig. 22, a base angle of the virtual isosceles trapezoid formed by the lines sequentially connecting the centers of the two adjacent first sub-pixels 111 in the first pixel row 121 and the centers of the two adjacent first sub-pixels 111 in the third pixel row 123 ranges from 75 degrees to 90 degrees. In this way, the pixel arrangement structure can make the distribution of the brightness centers of the virtual pixels formed by the first sub-pixels, the second sub-pixels and the third sub-pixels more uniform, thus the display problems such as "distortion" and "graininess" caused by the human eye can be better solved.

For example, as illustrated by Fig. 22, the base angle of the virtual isosceles trapezoid formed by the lines sequentially connecting the centers of the two adjacent first sub-pixels 111 in the first pixel row 121 and the centers of the two adjacent first sub-pixels 111 in the third pixel row 123 ranges from 86 degrees to 88 degrees, for example, 87 degrees. In this way, the pixel arrangement structure can make the distribution of the brightness centers of the virtual pixels formed by the first sub-pixels, the second sub-pixels and the third sub-pixels more uniform.

In some examples, as illustrated by Fig. 22, lines sequentially connecting centers of two adjacent third sub-pixels 113 in the second pixel row 122 and centers of two adjacent third sub-pixels 113 in the fourth pixel row 124 form a virtual quadrilateral.

For example, as illustrated by Fig. 22, four interior angles of the virtual quadrilateral formed by the lines sequentially connecting the centers of the two adjacent third sub-pixels 113 in the second pixel row 122 and the two adjacent third sub-pixels 113 in the fourth pixel row 124 are 83 degrees, 90 degrees, 97 degrees and 90 degrees respectively.

In some examples, as illustrated by Fig. 22, lines sequentially connecting centers of the two adjacent second sub-pixels 112 in the second pixel row 122 and centers of the two adjacent second sub-pixels 122 in the fourth pixel row 124 form at least one of a virtual isosceles trapezoid, a virtual square, and a virtual parallelogram.

In some examples, as illustrated by Fig. 22, each of the first sub-pixels 111 is located within a range of the virtual trapezoid formed by the lines sequentially connecting the centers of the two adjacent second sub-pixels 112 and the centers of the two adjacent third sub-pixels 113.

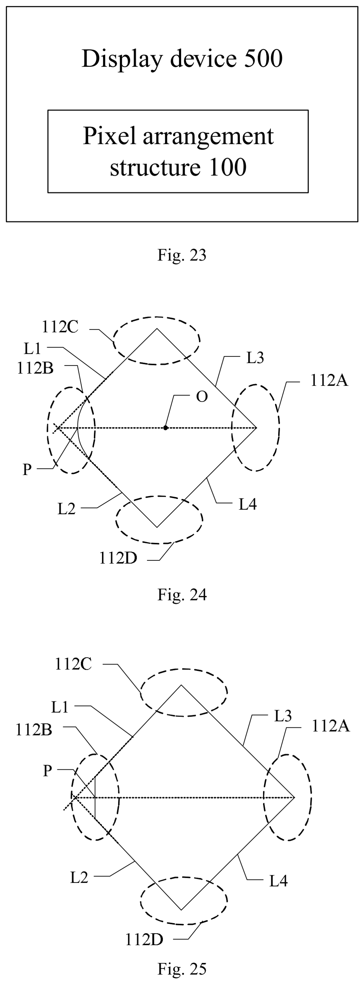

At least one embodiment of the present disclosure further provides a display device. Fig. 23 is a schematic diagram of a display device provided by an embodiment of the present disclosure. As illustrated by Fig. 23, the display device 500 includes the above-mentioned pixel arrangement structure 100. In this way, the display device can also make the distribution of virtual pixels (or white point pixels) more uniform, thus the display problems such as "distortion" and "graininess" caused by the human eye can be solved, and a better display effect can be achieved.

For example, the display device can be an electronic product with a display function such as a smartphone, a television, a computer, a tablet, a navigator, a car central control screen, and a smart watch.

At least one embodiment of the present disclosure further provides another planar schematic diagram of sub-pixels in a display substrate. Fig. 24 is a planar schematic diagram of another sub-pixel provided by an embodiment of the present disclosure. As illustrated by Fig. 24, the second sub-pixel 112 includes a first corner part 112A and a second corner part 112B; a distance from an intersection of the extension lines of the two straight sides L1 and L2 constituting the first corner part 112A to a center O of the sub-pixel is different from a distance from an intersection of the two straight sides L3 and L4 constituting the second corner part 112B to the center O of the sub-pixel. It should be noted that although Fig. 24 uses the second sub-pixel as an example to describe and illustrate the shape of the sub-pixel, however, the embodiments of the present disclosure are not limited to the fact that only the second sub-pixel can adopt the above-mentioned shape, and both the first sub-pixel and the third sub-pixel can adopt the above-mentioned shape.

In the display substrate provided by the embodiment of the present disclosure, by making the distance from an intersection point of the two straight sides forming the first corner part to the center of the sub-pixel and the distance from an intersection point of the two straight sides or its extension line forming the second corner part to the center of the sub-pixel different, to adjust the actual brightness center of each virtual pixel unit, the actual brightness center distribution of each virtual pixel in the pixel arrangement structure or display substrate is more uniform.

In some examples, as illustrated by Fig. 24, the second sub-pixel 112 further includes a third corner part 112C and a fourth corner part 112D arranged oppositely, the line connecting a vertex of the third corner part 112C and a vertex of the fourth corner part 112D divides the second sub-pixel into two parts, shapes of the two parts are different, and an area of a part where the second corner part 112B is located is smaller than an area of a part where the first corner part 112A is located.

For example, as illustrated by Fig. 24, a line connecting a vertex of the third corner part 112C and a vertex of the fourth corner part 112D divides the second sub-pixel into a first part and a second part, the first corner part is a corner part in the first part, the second corner part is a corner part in the second part, then a part where the first corner part is located refers to the first part, and a part where the second corner part is located refers to the second part.

For example, a ratio of an area of the part where the second corner part 112B is located to an area of the part where the first corner part 112A is located may be from 0.1 to 0.95. For example, the ratio of the area of the part where the second corner part 112B is located to the area of the part where the first corner part 112A is located may be from 0.3 to 0.8. For example, the ratio of the area of the part where the second corner part 112B is located to the area of the part where the first corner part 112A is located may be from 0.4 to 0.7.

It should be noted that, in general display substrates, shapes and areas of two parts where two opposite corner parts of each of the sub-pixels are located are the same, compared with this kind of display substrate, the display substrate provided by the present disclosure reduces an area of the part where the second corner part is located, by reducing the area of the part where the second corner part is located, the display substrate provided by the present disclosure can effectively improve the light transmittance of the display substrate in a case that the display substrate is used in a display device with an under-screen fingerprint function or an under-screen camera function.

For example, as illustrated by Fig. 24, in a case that the second corner part 112B includes a rounded chamfer and the other three corners are all acute angles or right angles, the first straight side L1 refers to a straight line connecting an end point of the curve forming the rounded chamfer near the third corner part 112C and a vertex of the third corner part 112C, the second straight side L2 refers to a straight line connecting an end point of the curve forming the rounded chamfer near the fourth corner part 112D and a vertex of the fourth corner part 112D, the third straight side L3 refers to the straight line connecting the vertex of the first corner part 112A and the vertex of the third corner part 113, and the fourth straight side L4 refers to a straight line connecting the vertex of the first corner part 112A and the vertex of the fourth corner part 114.

Fig. 25 is a planar schematic diagram of still another sub-pixel provided by an embodiment of the present disclosure. As illustrated by Fig. 24 and Fig. 25, the first corner part 112A, the third corner part 112C and the fourth corner part 112D mentioned above may include a right angle or an acute angle; an intersection point of the two lines forming the right angle or acute angle is a vertex of the angle. At this time, the corner part can be a range of x microns from the vertex as a center along a contour, and a value of x can be from 2 microns to 7 microns. As illustrated by Fig. 24, the above-mentioned vertex angle can also be a curve formed by a part where two sides of a certain vertex angle extend toward the vertex and meet, so that the vertex angle becomes a rounded chamfer, such as the second corner part 112B, the vertex of the corner part may be an intersection point P of an extension line of the two sides used to form the above-mentioned rounded chamfer and the intersection point P of the line connecting the vertex of the vertex opposite the rounded chamfer and the rounded chamfer, at this time, the corner part can be a range of x microns along the contour from the vertex P as the center, and the value of x can be 2 microns to 7 microns. In a case that the second corner part is rounded and the first corner part is a right angle or an acute angle, the distance from an intersection of the extension lines of the two straight sides constituting the first corner part to the center of the sub-pixel is less than the distance from an intersection of the extension lines of the two straight sides constituting the second corner part to the center of the sub-pixel.

The above-mentioned "round chamfer" is the vertex angle formed by a curve, the curve can be an arc or an irregular curve, for example, a curve, a wavy line intercepted from an ellipse. The embodiment of the present disclosure schematically shows that the curve has an outwardly convex shape relative to the center of the sub-pixel, but is not limited thereto, the curve may also have a shape that is concave inward relative to the center of the sub-pixel. For example, in a case that the curve is an arc, a central angle of the arc can range from 10° to 150°. For example, the central angle of the arc can range from 60° to 120°. For example, the range of the central angle of the arc may be 90°. For example, the first corner part 111 includes a rounded chamfer with a curve length of 10 microns to 60 microns.

In some examples, as illustrated by Fig. 25, the above-mentioned vertex angle can also be a line segment formed by an intersection of two sides of a certain vertex angle extending toward its vertex, so that the vertex angle becomes a flat chamfer, for example, the second corner part 112B includes the flat chamfer, a vertex of the corner part may be an intersection of the two sides forming the flat chamfer and an intersection point P of a line connecting the vertex of the vertex opposite the flat chamfer and the flat chamfer.

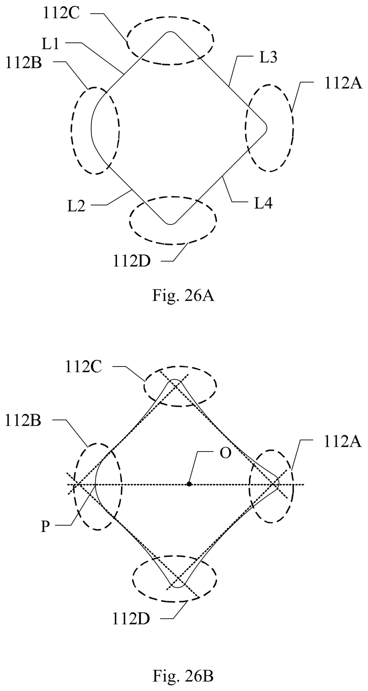

Fig. 26A is a planar schematic diagram of still another sub-pixel provided by an embodiment of the present disclosure; and Fig. 26B is a planar schematic diagram of still another sub-pixel provided by an embodiment of the present disclosure. As illustrated by Fig. 26A, the first corner part 112A, the second corner part 112B, the third corner part 112C and the fourth corner part 112D all include rounded chamfers, and a radius of a curvature of the rounded chamfer of the second corner part 112B is greater than a radius of a curvature of the rounded chamfer of the first corner part 112A. For example, in a case that the above four corner parts include rounded chamfers, a vertex of each of the corner parts may be an intersection point of the extension lines of the two sides used to form the above-mentioned rounded chamfer, and an intersection point of the line connecting the intersection point of the extension line of the two sides used to form the rounded chamfer opposite the rounded chamfer and the rounded chamfer, at this time, each of the corner parts can be in a range of x microns along the contour from the vertex of the corner part as the center, and a value of x can be from 2 microns to 7 microns.

For example, the radius of the curvature of the second corner part 112B may be 10% to 70% of a length of the straight edge forming the rounded chamfer. For example, the radius of the curvature of the second corner part 112B may be 20% to 50% of the length of the straight edge forming the rounded chamfer.

For example, the length of the connecting line between the vertex of the first corner part 112A and the vertex of the third corner part 112C may be 40 microns. For example, the radius of the curvature of the second corner part 112B may be from 5 microns to 20 microns. For example, the radius of the curvature of the second corner part 112B is less than 5 microns.

For example, the radius of the curvature of the rounded chamfer of the second corner part 111 is greater than the radius of the curvature of the rounded chamfers of the other three corner parts.

For example, as illustrated by Fig. 26B, the difference from the third type of sub-pixels shown in Fig. 26A is that an edge connecting adjacent corner parts is a curved edge instead of a straight edge. The definition of each of the corner parts and the definition of the vertices in the corner parts in this example are the same as in the example shown in Fig. 26A.

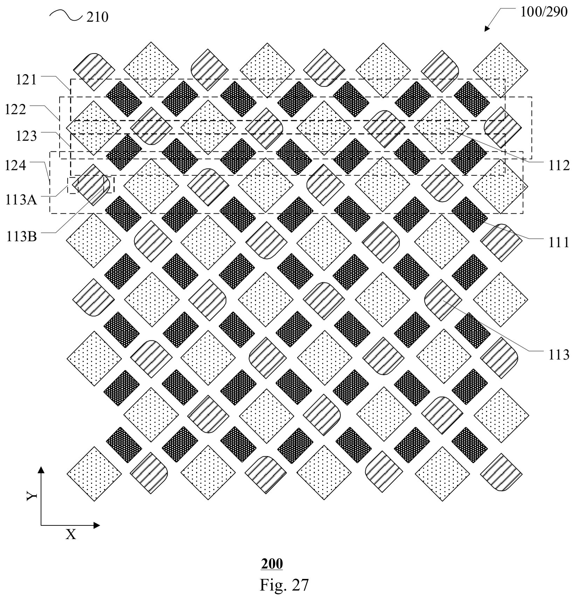

Fig. 27 is a planar schematic diagram of still another sub-pixel provided by an embodiment of the present disclosure. As illustrated by Fig. 27, the display substrate 200 includes a base substrate 210 and a pixel arrangement structure 100 located on the base substrate 210. The pixel arrangement structure 100 includes a first sub-pixel 111, a second sub-pixel 112 and a third sub-pixel 113, which are configured to emit light of different colors; the plurality of first sub-pixels 111 are arranged along the first direction to form a first type pixel row 121 or 123, the plurality of second sub-pixels 112 and the plurality of third sub-pixels 113 are arranged along the first direction and are alternately arranged to form a second type pixel row 122 or 124; a plurality of first type pixel rows and a plurality of second type pixel rows are arranged along a second direction intersecting the first direction, lines sequentially connecting the centers of four of the first sub-pixels 111 surrounding the third sub-pixel 113 form a virtual isosceles trapezoid, and lines sequentially connecting the centers of four of the second sub-pixels 112 surrounding the third sub-pixel 113 form a virtual quadrilateral. It should be noted that the difference from the previous embodiment is that, shapes of the second sub-pixel and the third sub-pixel in Fig. 27 are different, thus the schematic diagram of the pixel arrangement structure shown in Fig. 27 focuses more on the shapes of the sub-pixels, for the virtual shape formed by the positions of the sub-pixels and the lines sequentially connecting the centers of the sub-pixels in the pixel arrangement structure, please refer to the relevant descriptions of other embodiments. That is, the three sub-pixel shapes shown in Fig. 27 can be combined into the pixel arrangement structures shown in other embodiments.

In the pixel arrangement structure, the lines sequentially connecting the centers of the four first sub-pixels surrounding the third sub-pixel form a virtual isosceles trapezoid, and the lines sequentially connecting the centers of the four second sub-pixels surrounding the third sub-pixel form a virtual quadrilateral. In this way, the pixel arrangement structure can make the distribution of virtual pixels (or white point pixels) more uniform by modulating the positions of sub-pixels of different colors, thus the display problems such as "distortion" and "graininess" caused by the human eye can be solved, and a better display effect can be achieved.

For example, the first direction X and the second direction Y may be perpendicular to each other. Of course, embodiments of the present disclosure include but are not limited thereto, and the first direction X and the second direction Y may not be perpendicular to each other.

In some examples, as illustrated by Fig. 27, a shape of each of the third sub-pixels 113 includes a fifth corner part 113A and a sixth corner part 113B oppositely arranged, and a distance between a vertex of the fifth corner part 113A and a geometric center of a corresponding third sub-pixel 113 is greater than a distance between a vertex of the sixth corner part 113B and the geometric center of the corresponding third sub-pixel 113. That is, the shape of the third sub-pixel 113 is not an axially symmetrical shape. In this way, the pixel arrangement structure makes an edge of the sixth corner part more rounded, thus occurrence of color separation can be reduced or even avoided. In addition, the pixel arrangement structure can also flexibly adjust sizes and distances of different sub-pixels by arranging a third sub-pixel with the fifth corner part and the sixth corner part mentioned above, to achieve better display effect. It should be noted that the above-mentioned color indicators may be parameters such as brightness, color gamut, color temperature, and wavelength of light emitted by the sub-pixels.

It is worth noting that the geometric center of the above-mentioned sub-pixels can allow a certain error or range; and for example, the geometric centers of the sub-pixels may be a range with a radius of 3µm from the geometric centers of the sub-pixels.

In some examples, as illustrated by Fig. 27, a curvature of a curve where the vertex of the fifth corner part 113A is located is greater than a curvature of a curve where the vertex of the sixth corner part 113B is located. In this way, the pixel arrangement structure can make the edge of the second corner more rounded, thus the occurrence of color separation can be reduced or even avoided.

In some examples, as illustrated by Fig. 27, an arc length of an outer edge of the fifth corner part 113A is less than an arc length of an outer edge of the sixth corner part 113B.

In some examples, as illustrated by Fig. 27, the third sub-pixels 113 have different orientations, such as four orientations.

In some examples, as illustrated by Fig. 27, arrangement orders of the fifth corner part 113A and the sixth corner part 113B of two of the third sub-pixels 113 adjacent to each other in the first direction are different; for example, the arrangement orders of the fifth corner part 113A and the sixth corner part 113B of the two adjacent third sub-pixels 113 in the first direction are different, and the arrangement directions are perpendicular to each other. In some examples, as illustrated by Fig. 27, arrangement orders of the fifth corner part 113A and the sixth corner part 113B of two adjacent the third sub-pixels 113 in the second direction are different; for example, the arrangement orders of the fifth corner part 113A and the sixth corner part 113B of the two adjacent third sub-pixels 113 in the second direction are different, and the arrangement directions are perpendicular to each other.

In some examples, as illustrated by Fig. 27, lines sequentially connecting the centers of four third sub-pixels 113 around one second sub-pixel 112 may form a virtual quadrilateral, the second sub-pixel 112 is located in the virtual quadrilateral. The four third sub-pixels 113 around the second sub-pixel 112 respectively have different orientations, so that in a case that the display includes detailed images with a smaller number of sub-pixels, it can help reduce color casts and uniformize visual effects. It should be noted that the orientation of the above-mentioned third sub-pixel refers to the arrangement direction or order of the fifth corner part and the sixth corner part.

In some examples, as illustrated by Fig. 27, the shape of each of the second sub-pixels 112 is a rectangle or a square. Of course, the embodiments of the present disclosure include but are not limited thereto, and the shape of the second sub-pixel 112 may also adopt the same shape as the second sub-pixel in Fig. 2.

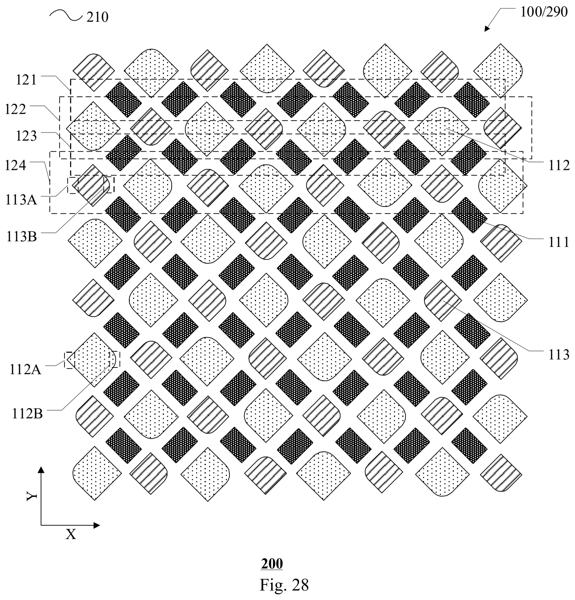

Fig. 28 is a planar schematic diagram of still another sub-pixel provided by an embodiment of the present disclosure. As illustrated by Fig. 28, different from the display substrate shown in Fig. 27, both the second sub-pixel and the third sub-pixel in Fig. 28 adopt directional design or asymmetric design.

As illustrated by Fig. 28, a shape of each of the second sub-pixel 112 includes a first corner part 112A and a second corner part 112B that are oppositely arranged, a distance between a vertex of the first corner part 112A and a geometric center of a corresponding second sub-pixel 112 is greater than a distance between a vertex of the second corner part 112B and the geometric center of the corresponding second sub-pixel 112. That is, the shape of the second sub-pixel 112 is not an axially symmetrical shape. A shape of each of the third sub-pixels 113 includes a fifth corner part 113A and a sixth corner part 113B oppositely arranged, a distance between a vertex of the fifth corner part 113A and a geometric center of a corresponding third sub-pixel 113 is greater than a distance between a vertex of the sixth corner part 113B and the geometric center of the corresponding third sub-pixel 113. That is to say, the shape of the third sub-pixel 113 is not an axially symmetrical shape.

In the pixel arrangement structure, by making the edges of the second corner part and the sixth corner part smoother, the occurrence of color separation can be reduced or even avoided. In addition, the pixel arrangement structure can also flexibly adjust different sub-pixels by arranging a second sub-pixel having the above-mentioned first corner part and the second corner part and a third sub-pixel having the above-mentioned fifth corner part and the sixth corner part, to achieve better display effects. It should be noted that the above-mentioned color indicators may be parameters such as brightness, color gamut, color temperature, and wavelength of light emitted by sub-pixels.

In some examples, as illustrated by Fig. 28, arrangement orders of the first corner part 112A and the second corner part 112B of two adjacent the second sub-pixels 112 in the first direction are different, for example, the arrangement orders are opposite. In this way, the pixel arrangement structure can make the orientation distribution of the second sub-pixels in the first direction relatively uniform, thus the display quality can be improved, for example, color shift can be improved.

In some examples, as illustrated by Fig. 28, the arrangement orders of the first corner parts 112A and the second corner parts 112B of two adjacent second sub-pixels 112 in the second direction are different, for example, the arrangement orders are opposite. In this way, the pixel arrangement structure can make the orientation distribution of the second sub-pixels in the second direction relatively uniform, thus the display quality can be improved, for example, color shift can be improved.

In some examples, as illustrated by Fig. 28, the second sub-pixels 112 have different orientations, such as four orientations; and the third sub-pixels 113 also have different orientations, such as four orientations.

In some examples, as illustrated by Fig. 28, arrangement orders of the fifth corner parts 113A and the sixth corner parts 113B of two adjacent the third sub-pixels 113 in the first direction are different; for example, the arrangement orders of the fifth corner parts 113A and the sixth corner parts 113B of two adjacent the third sub-pixels 113 in the first direction are different, and the arrangement directions are perpendicular to each other.

In some examples, as illustrated by Fig. 28, the arrangement orders of the fifth corner parts 113A and the sixth corner parts 113B of two adjacent the third sub-pixels 113 in the second direction are different; for example, the arrangement orders of the fifth corner part 113A and the sixth corner part 113B of two adjacent third sub-pixels 113 in the second direction are different, and the arrangement directions are perpendicular to each other.

In some examples, as illustrated by Fig. 28, lines sequentially connecting the centers of four third sub-pixels 113 which around one of the second sub-pixels 112 may form a virtual quadrilateral, the one of the second sub-pixels 112 is located in the virtual quadrilateral. The four third sub-pixels 113 around the one of the second sub-pixels 112 respectively have different orientations, thus in a case that the display includes detailed images with a smaller number of sub-pixels, it can help reduce color casts and uniformize visual effects. It should be noted that the above-mentioned third sub-pixel orientation refers to the arrangement direction or order of the fifth corner part and the sixth corner part.

In some examples, as illustrated by Fig. 28, lines sequentially connecting the centers of four second sub-pixels 112 around one of the third sub-pixels 113 may form a virtual quadrilateral, and the one of the third sub-pixels 113 is located in the virtual quadrilateral. The four second sub-pixels 112 around the one of the third sub-pixels 113 respectively have different orientations, thus in a case that the display includes detailed images with a smaller number of sub-pixels, it can help reduce color casts and uniformize visual effects. It should be noted that the above-mentioned second sub-pixel orientation refers to the arrangement direction or order of the first corner part and the second corner part.

The following points need to be explained:
(1) In the drawings of the embodiment of the present disclosure, only the structure related to the embodiment of the present disclosure is involved, and other structures can refer to the general design.
(2) Features in the same embodiment and different embodiments of the present disclosure can be combined with each other without conflict.

The above is only a specific embodiment of this disclosure, but the protection scope of this disclosure is not limited to this. Any person familiar with this technical field can easily think of changes or substitutions within the technical scope disclosed in this disclosure, which should be covered by this disclosure. Therefore, the scope of protection of this disclosure should be based on the scope of protection of the claims.

## Claims

1. A pixel arrangement structure, comprising at least one array unit, wherein the at least one array unit comprises:
a first pixel row, comprising a plurality of first sub-pixels arranged along a first direction;
a second pixel row, comprising a plurality of second sub-pixels and a plurality of third sub-pixels, which are arranged along the first direction and alternately arranged;
a third pixel row, comprising a plurality of first sub-pixels arranged along the first direction; and
a fourth pixel row, comprising a plurality of second sub-pixels and a plurality of third sub-pixels, which are arranged along the first direction and alternately arranged,
wherein the first pixel row, the second pixel row, the third pixel row and the fourth pixel row are arranged along a second direction intersecting the first direction, and a virtual isosceles trapezoid is formed by lines sequentially connecting centers of two adjacent first sub-pixels in the first pixel row and centers of two adjacent first sub-pixels in the third pixel row.

2. The pixel arrangement structure according to claim 1, wherein a base angle of the virtual isosceles trapezoid ranges from 75 degrees to 90 degrees.

3. The pixel arrangement structure according to claim 2, wherein the base angle of the virtual isosceles trapezoid ranges from 82 degrees to 84 degrees.

4. The pixel arrangement structure according to claim 2, wherein the base angle of the virtual isosceles trapezoid ranges from 84 degrees to 86 degrees.

5. The pixel arrangement structure according to any one of claims 1 to 4, wherein a virtual rectangle is formed by lines sequentially connecting centers of two adjacent third sub-pixels in the second pixel row and centers of two adjacent third sub-pixels in the fourth pixel row.

6. The pixel arrangement structure according to claim 5, wherein a virtual square is formed by the lines sequentially connecting the centers of the two adjacent third sub-pixels in the second pixel row and the centers of the two adjacent third sub-pixels in the fourth pixel row.

7. The pixel arrangement structure according to any one of claims 1 to 6, wherein at least one of a virtual isosceles trapezoid, a virtual square, and a virtual quadrilateral is formed by lines sequentially connecting centers of two adjacent second sub-pixels in the second pixel row and centers of two adjacent second sub-pixels in the fourth pixel row.

8. The pixel arrangement structure according to claim 7, wherein a shape of each of the second sub-pixels comprises a first corner part and a second corner part arranged oppositely, a distance between a vertex of the first corner part and a geometric center of a corresponding second sub-pixel is greater than a distance between a vertex of the second corner part and the geometric center of the corresponding second sub-pixel,
in the second pixel row and the fourth pixel row, arrangement orders of the first corner part and the second corner part of the two adjacent second sub-pixels are different.

9. The pixel arrangement structure according to claim 8, wherein arrangement orders of the first corner part and the second corner part of the two adjacent second sub-pixels in the second direction are opposite.

10. The pixel arrangement structure according to claim 8, wherein a curvature of a curve where the vertex of the first corner part is located is greater than a curvature of a curve where the vertex of the second corner part is located.

11. The pixel arrangement structure according to claim 8, wherein an arc length of an outer edge of the first corner part is less than an arc length of an outer edge of the second corner part.

12. The pixel arrangement structure according to any one of claims 1 to 11, wherein each of the first sub-pixels is located within a range of a virtual quadrilateral formed by lines sequentially connecting centers of two adjacent second sub-pixels and centers of two adjacent third sub-pixels.

13. The pixel arrangement structure according to claim 12, wherein a first distance and a second distance are provided between the first sub-pixel and the two second sub-pixels for forming the virtual quadrilateral respectively, a third distance and a fourth distance are provided between the first sub-pixel and the two third sub-pixels for forming the virtual quadrilateral respectively,
at least two of the first distance, the second distance, the third distance and the fourth distance are equal.

14. The pixel arrangement structure according to claim 13, wherein the first distance and the second distance are equal, and the third distance and the fourth distance are different.

15. The pixel arrangement structure according to claim 13, wherein the first distance, the second distance, the third distance and the fourth distance are equal.

16. The pixel arrangement structure according to any one of claims 1 to 15, wherein the first sub-pixels are configured to emit green light.

17. The pixel arrangement structure according to claim 16, wherein the second sub-pixels are configured to emit blue light, and the third sub-pixels are configured to emit red light.

18. The pixel arrangement structure according to claim 16, wherein the second sub-pixels are configured to emit red light, and the third sub-pixels are configured to emit blue light.

19. The pixel arrangement structure according to any one of claims 1 to 18, wherein the plurality of the second sub-pixels and the plurality of the third sub-pixels are alternately arranged along the second direction, to form a first pixel column,
in the first pixel column, an angle between a line connecting centers of one of the second sub-pixels and one of the third sub-pixels adjacent to each other and the second direction ranges from 1 degree to 15 degrees.

20. The pixel arrangement structure according to claim 19, wherein in the first pixel column, the angle between the line connecting the one of the second sub-pixels and the one of the third sub-pixels adjacent to each other and the second direction ranges from 5 degrees to 7 degrees.

21. The pixel arrangement structure according to claim 19, wherein a shape of each of the second sub-pixels comprises a first corner part and a second corner part arranged oppositely, a distance between a vertex of the first corner and a geometric center of a corresponding second sub-pixel is greater than a distance between a vertex of the second corner and the geometric center of the corresponding second sub-pixel,
in the first pixel column, the first corner part and the second corner part of the second sub-pixel are arranged oppositely in the second direction.

22. The pixel arrangement structure according to any one of claims 1 to 19, wherein the plurality of the first sub-pixels are arranged along the second direction, to form a second pixel column,
in the second pixel column, an angle between a line connecting centers of two adjacent first sub-pixels and the second direction ranges from 1 degree to 15 degrees.

23. The pixel arrangement structure according to claim 22, wherein the plurality of the first sub-pixels are arranged along the second direction, to form the second pixel column,
in the second pixel column, the angle between the line connecting centers of the two adjacent first sub-pixels and the second direction ranges from 6 degrees to 8 degrees.

24. The pixel arrangement structure according to any one of claims 1 to 23, wherein in the first pixel row, the plurality of the first sub-pixels are arranged at first intervals and second intervals along the first direction, the first intervals are smaller than the second intervals, and the first intervals and the second intervals are alternately arranged,
two opposite corner parts of two of the first sub-pixels on two sides of a corresponding first interval are chamfered to form first chamfered parts.

25. The pixel arrangement structure according to claim 24, wherein two opposite corner parts of two of the first sub-pixels on two sides of a corresponding second interval are chamfered to form second chamfered parts.

26. The pixel arrangement structure according to any one of claims 1 to 7, wherein a shape of each of the second sub-pixels comprises a first corner part and a second corner part arranged oppositely, a distance between a vertex of the first corner part and a geometric center of a corresponding second sub-pixel is greater than a distance between a vertex of the second corner part and the geometric center of the corresponding second sub-pixel,
in the second pixel row and the fourth pixel row, arrangement orders of the first corner part and the second corner part of two adjacent second sub-pixels are the same.

27. The pixel arrangement structure according to claim 26, wherein in the second pixel row and the fourth pixel row, the first corner parts and the second corner parts of the two adjacent second sub-pixels are arranged oppositely in the second direction.

28. The pixel arrangement structure according to claim 26, wherein a virtual square is formed by lines sequentially connecting centers of the two adjacent second sub-pixels in the second pixel row and centers of the two adjacent second sub-pixels in the fourth pixel row.

29. The pixel arrangement structure according to claim 28, wherein an angle between a line connecting centers of one of the second sub-pixels and one of the third sub-pixels adjacent to each other and located in the second pixel row and the fourth pixel row respectively and the first direction ranges from 1 degree to 10 degrees,
a line connecting centers of one of the second sub-pixels and one of the third sub-pixels adjacent to each other in the second direction is parallel to the second direction.

30. The pixel arrangement structure according to claim 29, wherein the angle between the line connecting the centers of one of the second sub-pixels and the one of the third sub-pixels adjacent to each other and located in the second pixel row and the fourth pixel row respectively and the first direction ranges 5 degrees to 9 degrees.

31. The pixel arrangement structure according to any one of claims 1 to 7, wherein a shape of each of the second sub-pixels comprises a first corner part and a second corner part arranged oppositely, a distance between a vertex of the first corner part and a geometric center of a corresponding second sub-pixel is greater than a distance between a vertex of the second corner part and the geometric center of the corresponding second sub-pixel,
in the second pixel row and the fourth pixel row, arrangement orders of the first corner part and the second corner part of two of the second sub-pixels adjacent to each other are the same,
an arrangement direction of the first corner and the second corner of the second sub-pixels in the second pixel row is perpendicular to an arrangement direction of the first corner part and the second corner part of the second sub-pixels in the fourth pixel row.

32. The pixel arrangement structure according to claim 31, wherein lines sequentially connecting centers of two adjacent second sub-pixels in the second pixel row and centers of two adjacent second sub-pixels in the fourth pixel row form the virtual isosceles trapezoid.

33. The pixel arrangement structure according to claim 31, wherein an angle between a line connecting centers of one of the second sub-pixels and one of the third sub-pixels adjacent to each other and located in the second pixel row and the fourth pixel row respectively and the first direction ranges from 1 degree to 15 degrees, and
an angle between a line connecting centers of one of the second sub-pixels and one of the third sub-pixels adjacent to each other in the second direction and the second direction ranges from 1 degree to 15 degrees.

34. The pixel arrangement structure according to claim 31, wherein an angle between a line connecting the centers of one of the second sub-pixels and the one of the third sub-pixels adjacent to each other and located in the second pixel row and the fourth pixel row respectively and the first direction ranges from 6 degrees to 8 degrees.

35. The pixel arrangement structure according to any one of claims 1 to 7, wherein a shape of each of the second sub-pixels comprises a first corner part and a second corner part arranged oppositely, a distance between a vertex of the first corner part and a geometric center of a corresponding second sub-pixel is greater than a distance between a vertex of the second corner part and the geometric center of the corresponding second sub-pixel,
in the second pixel row and the fourth pixel row, arrangement orders of the first corner part and the second corner part of two adjacent ones of the second sub-pixels are the same, and
an arrangement direction of the first corner part and the second corner part of the second sub-pixels in the second pixel row is opposite to an arrangement direction of the first corner part and the second corner part of the second sub-pixels in the fourth pixel row.

36. The pixel arrangement structure according to claim 35, wherein an angle between a line connecting centers of one of the second sub-pixels and one of the third sub-pixels adjacent to each other and located in the second pixel row and the fourth pixel row respectively and the first direction ranges from 1 degree to 15 degrees, and
an angle between a line connecting centers of one of the second sub-pixels and one of the third sub-pixels adjacent to each other in the second direction and the second direction ranges from 1 degree to 15 degrees.

37. The pixel arrangement structure according to claim 36, wherein the angle between the line connecting the centers of one of the second sub-pixels and one of the third sub-pixels adjacent to each other and located in the second pixel row and the fourth pixel row respectively and the first direction ranges from 7 degrees to 8 degrees.

38. The pixel arrangement structure according to any one of claims 1 to 7, wherein a shape of each of the second sub-pixels comprises a first corner part and a second corner part arranged oppositely, a distance between a vertex of the first corner part and a geometric center of a corresponding second sub-pixel is greater than a distance between a vertex of the second corner part and the geometric center of the corresponding second sub-pixel,
in the second pixel row and the fourth pixel row, arrangement orders of the first corner part and the second corner part of two adjacent ones of the second sub-pixels are the same,
an arrangement direction of the first corner part and the second corner part of the second sub-pixels in the second pixel row is perpendicular to an arrangement direction of the first corner part and the second corner part of the second sub-pixels in the fourth pixel row, and
arrangement orders of the first corner part and the second corner part of two adjacent ones of the second sub-pixels in the second direction are opposite.

39. The pixel arrangement structure according to claim 38, wherein an angle between a line connecting centers of one of the second sub-pixels and one of the third sub-pixels adjacent to each other and located in the second pixel row and the fourth pixel row respectively and the first direction ranges from 1 degree to 15 degrees, and
an angle between a line connecting centers of one of the second sub-pixels and one of the third sub-pixels adjacent to each other in the second direction and the second direction ranges from 1 degree to 15 degrees.

40. The pixel arrangement structure according to claim 39, wherein the angle between the line connecting the centers of the one of the second sub-pixels and the one of the third sub-pixels adjacent to each other and located in the second pixel row and the fourth pixel row respectively and the first direction ranges from 1 degree to 3 degrees, and
the angle between the line connecting the centers of the one of the second sub-pixels and the one of the third sub-pixels adjacent to each other in the second direction and the second direction ranges from 5 degrees to 7 degrees.

41. The pixel arrangement structure according to any one of claims 1 to 7, wherein a shape of each of the second sub-pixels comprises at least one of a first shape, a second shape and a third shape,
the first shape comprises a first corner part and a second corner part arranged oppositely, a distance between a vertex of the first corner part and a geometric center of a corresponding second sub-pixel is greater than a distance between a vertex of the second corner part and the geometric center of the corresponding second sub-pixel,
the second shape comprises a third corner part and a flattened part arranged oppositely, and an edge of the flattened part away from the third corner part is a straight line,
the third shape comprises a fourth corner part and a fifth corner part oppositely arranged in the first direction and a sixth corner part and a seventh corner part arranged oppositely in the second direction,
a distance between a vertex of the fourth corner part and a geometric center of the corresponding second sub-pixel is greater than a distance between a vertex of the fifth corner part and the geometric center of the corresponding second sub-pixel, a distance between a vertex of the sixth corner part and the geometric center of the corresponding second sub-pixel is greater than a distance between a vertex of the seventh corner part and the geometric center of the corresponding second sub-pixel, and
the fifth corner part and the seventh corner part are arranged adjacently.

42. The pixel arrangement structure according to claim 41, wherein a shape of each of the second sub-pixels in the second pixel row is different from a shape of each of the second sub-pixels in the fourth pixel row.

43. The pixel arrangement structure according to any one of claims 1 to 4, wherein a virtual square is formed by lines sequentially connecting centers of two adjacent second sub-pixels in the second pixel row and centers of two adjacent second sub-pixels in the fourth pixel row.

44. The pixel arrangement structure according to claim 43, wherein a virtual quadrilateral is formed by lines sequentially connecting centers of two adjacent third sub-pixels in the second pixel row and centers of two adjacent third sub-pixels in the fourth pixel row.

45. The pixel arrangement structure according to any one of claims 1 to 4, wherein a virtual quadrilateral is formed by lines sequentially connecting centers of two adjacent third sub-pixels in the second pixel row and centers of two adjacent third sub-pixels in the fourth pixel row.

46. The pixel arrangement structure according to claim 45, wherein at least one of a virtual isosceles trapezoid, a virtual square, and a virtual parallelogram is formed by lines sequentially connecting centers of two adjacent second sub-pixels in the second pixel row and centers of two adjacent second sub-pixels in the fourth pixel row.

47. The pixel arrangement structure according to claim 46, wherein each of the first sub-pixels is located within a range of a virtual trapezoid formed by lines sequentially connecting the centers of two adjacent second sub-pixels and the centers of two adjacent third sub-pixels.

48. A pixel arrangement structure, comprising first sub-pixels, second sub-pixels and third sub-pixels, wherein a plurality of the first sub-pixels are arranged along a first direction to form a first type pixel row, a plurality of the second sub-pixels and a plurality of the third sub-pixels are arranged along the first direction and are alternately arranged, to form a second type pixel row;
a plurality of first type pixel rows and a plurality of second type pixel rows are arranged along a second direction intersecting the first direction, lines sequentially connecting centers of four of the first sub-pixels surrounding one of the third sub-pixels form a virtual isosceles trapezoid, and lines sequentially connecting centers of four of the second sub-pixels surrounding the one of the third sub-pixels form a virtual quadrilateral.

49. The pixel arrangement structure according to claim 48, wherein the center of the one of the third sub-pixels is located at an intersection of diagonals of the virtual isosceles trapezoid, and the lines sequentially connecting the centers of the four of the second sub-pixels surrounding the one of the third sub-pixels form a virtual isosceles trapezoid.

50. The pixel arrangement structure according to claim 48, wherein the center of the one of the third sub-pixels is not located at an intersection of diagonals of the virtual isosceles trapezoid, and the lines sequentially connecting the centers of the four of the second sub-pixels surrounding the one of the third sub-pixels form a virtual parallelogram, a virtual rectangle or a virtual square.

51. The pixel arrangement structure according to claim 48, wherein the lines sequentially connecting the centers of the four of the second sub-pixels surrounding the one of the third sub-pixels form the virtual rectangle.

52. The pixel arrangement structure according to claim 51, wherein a center of at least one of the third sub-pixels is located at an intersection of diagonals of a virtual rectangle formed by lines sequentially connecting centers of four of the third sub-pixels surrounding the at least one of the third sub-pixels, and a center of at least one of the third sub-pixels is not located at an intersection of diagonals of a virtual rectangle formed by lines sequentially connecting centers of four of the third sub-pixels surrounding the at least one of the third sub-pixels.

53. The pixel arrangement structure according to claim 48, wherein a plurality of the third sub-pixels adjacent in the second direction are arranged at intervals according to third intervals and fourth intervals along the second direction, and sizes of the third intervals in the second direction are smaller than sizes of the fourth intervals in the second direction.

54. A display device, comprising the pixel arrangement structure according to any one of claims 1 to 53.
